# EUROPEAN PATENT APPLICATION

(11) **EP 3 858 927 A1**
(43) Date of publication of application: **04.08.2021**
(21) Application number: 19865754.6
(22) Date of filing: 24.09.2019
(51) Int. Cl.: C09D 11/52, H01L 51/50

(54) **INK COMPOSITION**

(30) Priority: 25.09.2018 JP 2018179065
(71) Applicant: Nissan Chemical Corporation, Tokyo 103-6119 (JP)
(72) Inventor: SHIBATA, Chika, Funabashi-shi, Chiba 274-0052 (JP); HIGASHI, Masayuki, Funabashi-shi, Chiba 274-0052 (JP); KANNO, Yuta, Funabashi-shi, Chiba 274-0052 (JP)
(74) Representative: Mewburn Ellis LLP
(86) International application number: PCT/JP2019/037268
(87) International publication number: WO 2020/067011

(57) **Abstract**

The present invention relates to an ink composition containing:
(a) a charge transporting material;
(b) one or more metal oxide nanoparticles; and
(c) a liquid carrier containing:
(c-1) a first hydrophilic glycol-based solvent having a boiling point of bp¹ (°C),
(c-2) a second hydrophilic glycol-based solvent having a boiling point of bp² (°C), and
(c-3) an organic solvent having a boiling point of bp³ (°C),
wherein bp¹ < bp³ < bp².

## Description

### TECHNICAL FIELD

The present invention relates to an ink composition comprising a charge transporting material, metal oxide nanoparticles, and a liquid carrier of a certain composition.

### BACKGROUND ART

Although useful advances are being made in energy saving devices such as, for example, organic-based organic light emitting diodes (OLEDs), polymer light emitting diodes (PLEDs), phosphorescent organic light emitting diodes (PHOLEDs), and organic photovoltaic devices (OPVs), further improvements are still needed in providing better materials processing and/or device performance for commercialization. For example, one promising type of material used in organic electronics is conducting polymers including, for example, polythiophenes. However, problems can arise with polymers' purity, processability, and instability in their neutral and/or conductive states. Also, it is important to have very good control over the solubility of polymers utilized in alternating layers of various devices' architectures (e.g., orthogonal or alternating solubility properties among adjacent layers in particular device architecture). These layers, also known as hole injection layers (HILs) and hole transport layers (HTLs), for example, can present difficult problems in view of competing demands and the need for very thin, but high quality, films.

In a typical OLED device stack, the refractive index for most p-doped polymeric HILs is around 1.5, such as HILs comprising PEDOT:PSS, while the emissive materials generally have a refractive index that is substantially higher (1.7 or higher). As a result, additional total internal reflection occurs at the EML/HIL (or HTL/HIL) and HIL/ITO interfaces, leading to reduced light extraction efficiency.

There is an ongoing unresolved need for a good platform system to control properties of hole injection and transport layers, such as solubility, thermal/chemical stability, and electronic energy levels, such as HOMO and LUMO, so that the compounds can be adapted for different applications and to function with different compounds, such as light emitting layers, photoactive layers, and electrodes. Good solubility, intractability, and thermal stability properties are important. Also of importance is the ability to tune HIL resistivity and HIL layer thickness while retaining high transparency, low absorptivity, low internal reflection, low operating voltage, within the OLED system, and prolonged lifetime, among other properties. The ability to formulate the system for a particular application and provide the required balance of such properties is also important.

One method known in the art for forming an HIL and a charge transporting film of an organic EL device such as an HIL is applying an ink composition consisting mainly of a liquid carrier in which a conductive polymer is dispersed or dissolved on a substrate (more precisely, on a thin film electrode formed on the substrate in many cases) to form a coating film, and drying the obtained coating film to remove the liquid carrier, thereby forming a charge transporting film. Since an organic EL device is deteriorated by contact with moisture, it is preferable that the ink composition be non-aqueous. In addition, non-aqueous ink compositions of various compositions have been proposed for the purpose of, among others, improving various characteristics of charge transporting films and organic EL devices comprising the same.

Patent Document 1 discloses an ink composition comprising an amine compound. Not only does the presence of an amine compound in the ink composition result in an ink composition having good shelf life and stability, but thin films formed from the ink composition exhibit excellent homogeneity, and OLED devices comprising HILs formed from the ink composition exhibit good performance.

Patent Documents 2 and 3 disclose ink compositions comprising metal and/or semimetal nanoparticles. These nanoparticles are useful, for example, for improving characteristics such as luminance, thermal stability, hole injectability, and the like in an organic EL device, and for reducing variation in characteristics among finished products.

Various methods for applying such ink compositions are known in the art. One example of such a method is an ink jetting method (droplet discharge method) in which an ink composition is discharged as minute droplets from a nozzle and adhered to an object to be coated. When, in order to manufacture an organic EL device, a charge transporting film is formed on a substrate using an ink jetting method, a method is often employed in which a bank (partition wall) is formed on a thin film electrode (a patterned thin film electrode in many cases) formed on the substrate so that the desired region on the thin film electrode is partitioned off by the bank as a film formation region, and an ink composition is applied only to the film formation region by an ink jetting method to form a charge transporting film.

A charge transporting film formed as described above preferably has a thickness uniform over the entire film. In reality, however, particularly when the charge transporting film is formed by a method that uses a bank as described above, the resulting charge transporting film may have non-uniform thickness. One such example is a situation in which the thickness at the periphery of the formed charge transporting film increases along the direction from the center toward the edge of the film. This arises from the increase in thickness at the periphery of the formed coating film along the direction from the center of the coating film toward the edge (i.e. the area where the coating film comes in contact with the side of the bank) caused by the climbing of the side of the bank by the ink composition applied in the film formation region. A charge transporting film formed from a coating film in this state will have non-uniform thickness as described above. Herein, this phenomenon, in which the ink composition climbs the side of the bank, is referred to as the "pile-up phenomenon" or simply "pile-up."

The side of the bank that comes in contact with the ink composition (coating film) is often subjected to treatment (e.g., certain plasma treatments) for imparting repellency to the ink composition so that the applied ink composition can form a coating film having a uniform thickness in the film formation region without adhering to the side of the bank; and the surface of the substrate (thin film electrode) serving as the film formation region is often subjected to treatment (e.g., certain other types of plasma treatment) for imparting affinity to the ink composition. Herein, a substrate that has been subjected to such treatment is referred to as a "substrate having a liquid repellent bank." However, even if a substrate having a liquid repellent bank is used, the pile-up phenomenon may not be sufficiently suppressed in some cases.

As described above, various additional components are often added to the ink composition for such purposes as improving various characteristics of the charge transporting film and an organic EL device comprising the same. Depending on the added components, however, this may induce the pile-up phenomenon. Indeed, as described below, the present inventors have found that under certain conditions, the addition of metal oxide nanoparticles to an ink composition results in a significant manifestation of the pile-up phenomenon.

The non-uniformity of the thickness of the charge transporting film caused by the pile-up phenomenon may cause electrical defects (the generation of leakage current, short-circuit, etc.) through regions where the thickness of the film is increased, which leads to a shortened lifetime of the organic EL device. In addition, the non-uniformity of the thickness of the charge transporting film causes thickness non-uniformity in the light emitting layer adjacent thereto, and this, together with the electrical defects, may cause an uneven emission of light in the organic EL device.

As a means for suppressing the pile-up phenomenon, for example, it has been proposed to suitably adjust the composition of the liquid carrier in an ink composition (see Patent Documents 4 and 5). However, the ink composition in this case is composed only of a liquid carrier and a conductive material, and is not intended to suppress the pile-up phenomenon in an ink composition comprising additional components as described above.

That is, no means for suppressing a pile-up phenomenon in an ink composition comprising an additional component for such purposes as improving characteristics of the charge transporting film or the organic EL device are as yet known.

### PRIOR ART DOCUMENTS

### Patent Documents

Patent Document 1: WO 2016/171935
Patent Document 2: WO 2017/014945
Patent Document 3: WO 2017/014946
Patent Document 4: WO 2016/140205
Patent Document 5: JP-A-2015-185640

### SUMMARY

### Problems to be Solved by the Invention

Under these circumstances, the present inventors have carried out intensive research to develop a means for suppressing the pile-up phenomenon in an ink composition comprising an additional component as described above. As a result, the present inventors have surprisingly found that in an ink composition prepared by adding metal oxide nanoparticles to a combination of a charge transporting material and a liquid carrier, there is a correlation between the state of dispersion of the metal oxide nanoparticles in the composition and the occurrence of the pile-up phenomenon, and that the more uniform the dispersion, the more pronounced the occurrence of the pile-up phenomenon.

The present inventors have also found that the composition of the solvent used, especially the organic solvent, affects the state of dispersion of the metal oxide nanoparticles in the ink composition, and that use of a specific composition for the organic solvent allows this state of dispersion to be properly controlled, especially during the process of volatilizing the solvent, thereby suppressing the pile-up phenomenon.

The present inventors have further found that the suppression of the pile-up phenomenon tended to have the opposite effect of deteriorating certain characteristics, such as current efficiency, of the obtained organic EL device when an organic solvent of a specific composition as described above was not used as the liquid carrier, whereas, surprisingly, it did not excessively deteriorate organic EL device characteristics, when an organic solvent of a specific composition as described above were used as the liquid carrier.

On the basis of the new findings above, the present invention has been completed.

Accordingly, a main object of the present invention is to provide an ink composition that provides a charge transporting film having uniform thickness without excessively deteriorating organic EL device characteristics.

The above and other objects, features and advantages of the present invention will become apparent from the following detailed description and claims taken in conjunction with the accompanying drawings.

That is, the present invention provides the following inventions.
1. An ink composition comprising:
   (a) a charge transporting material;
   (b) one or more metal oxide nanoparticles; and
   (c) a liquid carrier comprising:
      (c-1) a first hydrophilic glycol-based solvent having a boiling point of bp¹ (°C),
      (c-2) a second hydrophilic glycol-based solvent having a boiling point of bp² (°C), and
      (c-3) an organic solvent having a boiling point of bp³ (°C),
         wherein bp¹ < bp³ < bp².
2. The ink composition according to preceding item 1, wherein the solvent (c-3) is a hydrophobic glycol-based solvent, a nitrile, an alcohol, an aromatic ether, an aromatic ester, or an aromatic hydrocarbon.
3. The ink composition according to preceding item 1 or 2, wherein the solvent (c-3) is a hydrophobic glycol-based solvent.
4. The ink composition of any one of preceding items 1 to 3, wherein the solvents (c-1) and (c-2) are both glycol solvents and the solvent (c-3) is a glycol diether solvent.
5. The ink composition of any one of preceding items 1 to 4, wherein bp¹ is 180°C or higher, bp² is 270°C or higher, and bp³ is 200°C or higher and lower than 270°C.
6. The ink composition of preceding item 1, wherein the solvent (c-3) is a mixture of two or more organic solvents, comprising one or more glycol diether solvents.
7. The ink composition of any one of preceding items 1 to 6, wherein the solvent (c-1) is ethylene glycol and the solvent (c-2) is triethylene glycol.
8. The ink composition of any one of preceding items 1 to 7, wherein the weight ratio ((c-1) : (c-2)) of the solvent (c-1) to the solvent (c-2) is 29:1 to 8:7.
9. The ink composition of any one of preceding items 1 to 8, wherein the weight of the solvent (c-1) is 16 to 29% of the total weight of the liquid carrier (c), and the weight of the solvent (c-2) is 14 to 1% of the total weight of the liquid carrier (c).
10. The ink composition according to any one of preceding items 1 to 9, wherein the metal oxide nanoparticles (b) comprise B₂O₃, B₂O, SiO₂, SiO, GeO₂, GeO, As₂O₄, As₂O₃, As₂O₅, Sb₂O₃, TeO₂, SnO₂, SnO, or mixtures thereof.
11. The ink composition according to preceding item 10, wherein the metal oxide nanoparticles (b) comprise SiO₂.
12. The ink composition according to any one of preceding items 1 to 11, wherein the charge transporting material (a) is a polythiophene.
13. The ink composition according to preceding item 12, wherein the polythiophene is a polythiophene comprising a repeating unit represented by formula (I) below: 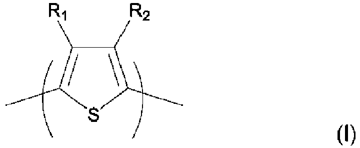 wherein R₁ and R₂ are each, independently, H, alkyl, fluoroalkyl, alkoxy, fluoroalkoxy, aryloxy, -SO₃M, or -O-[Z-O]ₚ-Rₑ; or R₁ and R₂ together form -O-Z-O-;
   wherein
   M is H, an alkali metal, ammonium, a monoalkylammonium, a dialkylammonium, or a trialkylammonium,
   Z is a hydrocarbylene group optionally substituted with a halogen or Y, wherein Y is a straight or branched chain alkyl or alkoxyalkyl group having 1 to 10 carbons, wherein the alkyl or alkoxyalkyl group may be substituted at any position with a sulfonic acid group,
   p is an integer equal to or greater than 1, and
   Rₑ is H, alkyl, fluoroalkyl, or aryl.
14. The ink composition according to preceding item 13, wherein R₁ and R₂ are each, independently, H, fluoroalkyl, -SO₃M, -O[C(RₐR_{b})-C(R_{c}R_{d})-O]ₚ-Rₑ, or - OR_{f}; or R₁ and R₂ together form -O-(CH₂)_{q}-O-, wherein (CH₂)_{q} is optionally substituted with Y;
   wherein M is H, an alkali metal, ammonium, a monoalkylammonium, a dialkylammonium, or a trialkylammonium, and each occurrence of Rₐ, R_{b}, R_{c}, and R_{d} is each, independently, H, halogen, alkyl, fluoroalkyl, or aryl; Rₑ is H, alkyl, fluoroalkyl, or aryl; p is 1, 2, or 3; and R_{f} is alkyl, fluoroalkyl, or aryl; q is 1, 2, or 3; and Y is a straight or branched chain alkoxyalkyl group having 1 to 10 carbons, wherein the alkoxyalkyl group may be substituted at any position with a sulfonic acid group.
15. The ink composition according to preceding item 14, wherein R₁ is H and R₂ is other than H.
16. The ink composition according to preceding item 14, wherein R₁ and R₂ are both other than H.
17. The ink composition according to preceding item 16, wherein R₁ and R₂ are each, independently, -O[C(RₐR_{b})-C(R_{c}R_{d})-O]ₚ-Rₑ, or -OR_{f}; or R₁ and R₂ together form -O-(CH₂)_{q}-O-.
18. The ink composition according to preceding item 17, wherein R₁ and R₂ are both -O[C(RₐR_{b})-C(R_{c}R_{d})-O]ₚ-Rₑ.
19. The ink composition according to preceding item 14, wherein each occurrence of Rₐ, R_{b}, R_{c}, and R_{d} is each, independently, H, (C₁-C₈) alkyl, (C₁-C₈) fluoroalkyl, or phenyl; and Rₑ is (C₁-C₈) alkyl, (C₁-C₈) fluoroalkyl, or phenyl.
20. The ink composition according to any one of preceding items 12 to 14, wherein the polythiophene comprises a repeating unit selected from the group consisting of 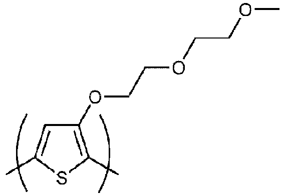 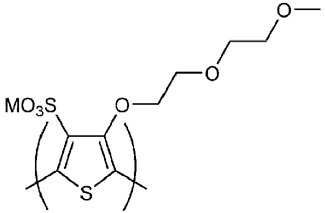 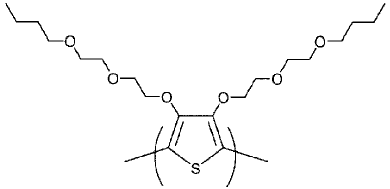 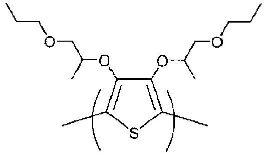 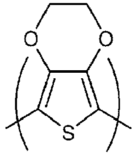 and combinations thereof, wherein M is H, an alkali metal, ammonium, a monoalkylammonium, a dialkylammonium, or a trialkylammonium.
21. The ink composition according to any one of preceding items 12 to 20, wherein the polythiophene is sulfonated.
22. The ink composition according to any one of preceding items 12 to 21, wherein the polythiophene is sulfonated poly(3-MEET).
23. The ink composition according to any one of preceding items 12 to 22, wherein the polythiophene comprises repeating units represented by formula (I) above in an amount of greater than 50% by weight, typically greater than 80% by weight, more typically greater than 90% by weight, even more typically greater than 95% by weight, based on the total weight of the repeating units.
24. The ink composition according to any one of preceding items 1 to 23, further comprising a synthetic polymer comprising one or more acidic groups.
25. The ink composition according to preceding item 24, wherein the synthetic polymer is a polymeric acid comprising one or more repeating units comprising at least one alkyl or alkoxy group substituted by at least one fluorine atom and at least one sulfonic acid (-SO₃H) moiety, wherein said alkyl or alkoxy group is optionally interrupted by at least one ether linking (-O-) group.
26. The ink composition according to preceding item 25, wherein the polymeric acid comprises a repeating unit represented by formula (II) below and a repeating unit represented by formula (III) below: 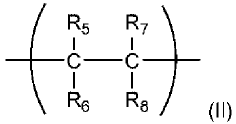 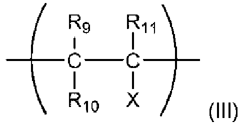 wherein
   each occurrence of R₅, R₆, R₇, R₈, R₉, R₁₀, and R₁₁ is, independently, H, halogen, fluoroalkyl, or perfluoroalkyl; and
   X is -[OC(RₕRᵢ)-C(RⱼRₖ)]_{q}-O-[CR₁Rₘ]_{z}-SO₃H,
      wherein
      each occurrence of Rₕ, Rᵢ, Rⱼ, Rₖ, Rₗ and Rₘ is, independently, H, halogen, fluoroalkyl, or perfluoroalkyl;
      q is 0 to 10; and
      z is 1 to 5.
27. The ink composition according to preceding item 24, wherein the synthetic polymer is a polyether sulfone comprising one or more repeating units comprising at least one sulfonic acid (-SO₃H) moiety.
28. The ink composition according to any one of preceding items 1 to 27, further comprising at least one amine compound.
29. The ink composition according to preceding item 28, wherein the amine compound comprises a tertiary alkylamine compound and an amine compound other than a tertiary alkylamine compound.
30. The ink composition according to preceding item 29, wherein the amine compound other than a tertiary alkylamine compound is a primary alkylamine compound.
31. The ink composition according to preceding item 30, wherein the primary alkylamine compound is at least one selected from the group consisting of ethylamine, n-butylamine, t-butylamine, n-hexylamine, 2-ethylhexylamine, n-decylamine, and ethylenediamine.
32. The ink composition according to preceding item 30, wherein the primary alkylamine compound is 2-ethylhexylamine or n-butylamine.

### Effect of the Invention

The ink composition of the present invention suppresses the pile-up phenomenon observed when a charge transporting film is formed by applying the ink composition to a substrate having a liquid repellent bank and drying the same, thereby allowing a charge transporting film having a uniform thickness to be easily obtained. Further, the ink composition of the present invention does not excessively deteriorate organic EL device characteristics.

### Brief Description of the Drawings

FIG. 1 is a graph comparing the cross-sectional shapes of the charge transporting films obtained in Examples 1 to 5 and Comparative Example 1. The lower panel shows an enlarged view for the aperture range of 80 to 90 µm in the upper panel.
FIG. 2 is a graph comparing the cross-sectional shapes of the charge transporting films obtained in Examples 6 to 7 and Comparative Example 1. The lower panel shows an enlarged view for the aperture range of 80 to 90 µm in the upper panel.

### Description of Embodiments

As used herein, the terms "a", "an", or "the" means "one or more" or "at least one" unless otherwise stated.

As used herein, the term "comprises" includes "consists essentially of' and "consists of." The term "comprising" includes "consisting essentially of' and "consisting of."

The phrase "free of' means that there is no external addition of the material modified by the phrase and that there is no detectable amount of the material that may be observed by analytical techniques known to the ordinarily-skilled artisan, such as, for example, gas or liquid chromatography, spectrophotometry, optical microscopy, and the like.

Throughout the present invention, various publications are incorporated by reference. Should the meaning of any language in such publications incorporated by reference conflict with the meaning of the language of the present invention, the meaning of the language of the present invention shall take precedence, unless otherwise indicated.

As used herein, the terminology "(Cₓ-C_{y})" in reference to an organic group, wherein x and y are each integers, means that the group may contain from x carbon atoms to y carbon atoms per group.

As used herein, the term "alkyl" means a monovalent straight or branched saturated hydrocarbon radical, more typically, a monovalent straight or branched saturated (C₁-C₄₀) hydrocarbon radical, such as, for example, methyl, ethyl, n-propyl, isopropyl, n-butyl, isobutyl, tert-butyl, hexyl, 2-ethylhexyl, octyl, hexadecyl, octadecyl, eicosyl, behenyl, tricontyl, and tetracontyl.

As used herein, the term "fluoroalkyl" means an alkyl radical as defined herein, more typically a (C₁-C₄₀) alkyl radical that is substituted with one or more fluorine atoms. Examples of fluoroalkyl groups include, for example, difluoromethyl, trifluoromethyl, perfluoroalkyl, 1H,1H,2H,2H-perfluorooctyl, perfluoroethyl, and - CH₂CF₃.

As used herein, the term "hydrocarbylene" means a divalent radical formed by removing two hydrogen atoms from a hydrocarbon, typically a (C₁-C₄₀) hydrocarbon. Hydrocarbylene groups may be straight, branched or cyclic, and may be saturated or unsaturated. Examples of hydrocarbylene groups include, but are not limited to, methylene, ethylene, 1-methylethylene, 1-phenylethylene, propylene, butylene, 1,2-benzene; 1,3-benzene; 1,4-benzene; and 2,6-naphthalene.

As used herein, the term "alkoxy" means a monovalent radical denoted as - O-alkyl, wherein the alkyl group is as defined herein. Examples of alkoxy groups, include, but are not limited to, methoxy, ethoxy, n-propoxy, isopropoxy, n-butoxy, isobutoxy, and tert-butoxy.

As used herein, the term "aryl" means a monovalent unsaturated hydrocarbon radical containing one or more six-membered carbon rings in which the unsaturation may be represented by three conjugated double bonds. Aryl radicals include monocyclic aryl and polycyclic aryl. Polycyclic aryl refers to a monovalent unsaturated hydrocarbon radical containing more than one six-membered carbon ring in which the unsaturation may be represented by three conjugated double bonds wherein adjacent rings may be linked to each other by one or more bonds or divalent bridging groups or may be fused together. Examples of aryl radicals include, but are not limited to, phenyl, anthracenyl, naphthyl, phenanthrenyl, fluorenyl, and pyrenyl.

As used herein, the term "aryloxy" means a monovalent radical denoted as - O-aryl, wherein the aryl group is as defined herein. Examples of aryloxy groups, include, but are not limited to, phenoxy, anthracenoxy, naphthoxy, phenanthrenoxy, and fluorenoxy.

Any substituent or radical described herein may optionally be substituted at one or more carbon atoms with one or more, same or different, substituents described herein. For instance, a hydrocarbylene group may be further substituted with an aryl group or an alkyl group. Any substituent or radical described herein may also optionally be substituted at one or more carbon atoms with one or more substituents selected from the group consisting of halogen, such as, for example, F, Cl, Br, and I; nitro (NO₂), cyano (CN), and hydroxy (OH).

As used herein, the term "hole carrier compound" refers to any compound that is capable of facilitating the movement of holes, i.e., positive charge carriers, and/or blocking the movement of electrons, for example, in an electronic device. Hole carrier compounds include compounds useful in layers (HTLs), hole injection layers (HILs) and electron blocking layers (EBLs) of electronic devices, typically organic electronic devices, such as, for example, organic light emitting devices.

As used herein, the term "doped" in reference to a hole carrier compound, for example, a polythiophene, means that the hole carrier compound has undergone a chemical transformation, typically an oxidation or reduction reaction, more typically an oxidation reaction, facilitated by a dopant. As used herein, the term "dopant" refers to a substance that oxidizes or reduces, typically oxidizes, a hole carrier compound, for example, a polythiophene. Herein, the process wherein a hole carrier compound undergoes a chemical transformation, typically an oxidation or reduction reaction, more typically an oxidation reaction, facilitated by a dopant is called a "doping reaction" or simply "doping". Doping alters the properties of the polythiophene, which properties may include, but may not be limited to, electrical properties, such as resistivity and work function, mechanical properties, and optical properties. In the course of a doping reaction, the hole carrier compound becomes charged, and the dopant, as a result of the doping reaction, becomes the oppositely-charged counterion for the doped hole carrier compound. As used herein, a substance must chemically react, oxidize or reduce, typically oxidize, a hole carrier compound to be referred to as a dopant. Substances that do not react with the hole carrier compound but may act as counterions are not considered dopants according to the present invention. Accordingly, the term "undoped" in reference to a hole carrier compound, for example a polythiophene, means that the hole carrier compound has not undergone a doping reaction as described herein.

The present invention relates to an ink composition comprising:
(a) a charge transporting material;
(b) one or more metal oxide nanoparticles; and
(c) a liquid carrier comprising:
   (c-1) a first hydrophilic glycol-based solvent having a boiling point of bp¹ (°C),
   (c-2) a second hydrophilic glycol-based solvent having a boiling point of bp² (°C), and
   (c-3) an organic solvent having a boiling point of bp³ (°C),
      wherein bp¹ < bp³ < bp².

The ink composition of the present disclosure may be non-aqueous or may comprise water, but is preferably non-aqueous from the perspective of process compatibility in inkjet coating, the perspective of the storage stability of the ink, or the perspective of lowering the voltage or extending the life of OLEDs comprising charge transporting films obtained from the composition. As used herein, "non-aqueous" means that the total amount of water in the ink composition of the present disclosure is from 0 to 2 wt. %, with respect to the total amount of ink composition. Typically, the total amount of water in the ink composition is from 0 to 1 wt. %, more typically from 0 to 0.5 wt. %, with respect to the total amount of the ink composition. In an embodiment, the ink composition of the present disclosure is substantially free of water.

The ink composition of the present invention comprises a charge transporting material (a). Although various materials that can be used as the charge transporting material (a) are known, in the present invention, it is preferable to use a polythiophene for the charge transporting material (a).

The polythiophene that can be used for the charge transporting material (a) is a compound composed of a plurality of structural units, which may be the same or different, derived from thiophene derivatives, having an average molecular weight of 1,000 to 1,000,000. In the polythiophene, two adjacent structural units are bonded to each other. When the polythiophene comprises two or more different structural units, the structural units may be arranged in any order.

In a preferred embodiment, poly(3,4-ethylenedioxythiophene) (PEDOT) is not included in the scope of the polythiophene compound contained in the composition of the present invention from the perspective of reproducibly obtaining a charge transporting film having excellent flatness and providing excellent lifetime characteristics when applied in an organic EL device.

In a certain embodiment of the present invention, the polythiophene compound contained in the composition of the present invention is free of fluorine atoms, from the perspective of obtaining a composition that gives a charge transporting film that, on applying a coating on top of it to form a functional film, can reproducibly give rise to a functional film having excellent flatness by suppressing repellence of the coating film.

Polythiophenes that are suitable for use in present disclosure are polythiophenes comprising a repeating unit represented by formula (I) below. 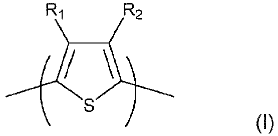 wherein R₁ and R₂ are each, independently, H, alkyl, fluoroalkyl, alkoxy, fluoroalkoxy, aryloxy, -SO₃M, or -O-[Z-O]ₚ-Rₑ; or R₁ and R₂ together form -O-Z-O-;
wherein
M is H, an alkali metal, ammonium, a monoalkylammonium, a dialkylammonium, or a trialkylammonium,
Z is a hydrocarbylene group optionally substituted with halogen or Y, wherein Y is a straight or branched chain alkyl or alkoxyalkyl group having 1 to 10 carbons, wherein the alkyl or alkoxyalkyl group may be substituted at any position with a sulfonic acid group,
p is an integer equal to or greater than 1, and
Rₑ is H, alkyl, fluoroalkyl, or aryl.
The polythiophene may be used alone or in combination of two or more kinds.

In an embodiment, R₁ and R₂ are each, independently, H, fluoroalkyl, - SO₃M, -O[C(RₐR_{b})-C(R_{c}R_{d})-O]ₚ-Rₑ, or -OR_{f}; or R₁ and R₂ together form -O-(CH₂)_{q}-O-, wherein (CH₂)_{q} is optionally substituted with Y; wherein M is H, an alkali metal, ammonium, a monoalkylammonium, a dialkylammonium, or a trialkylammonium, and each occurrence of Rₐ, R_{b}, R_{c}, and R_{d} is each, independently, H, halogen, alkyl, fluoroalkyl, or aryl; Rₑ is H, alkyl, fluoroalkyl, or aryl; p is 1, 2, or 3; R_{f} is alkyl, fluoroalkyl, or aryl; q is 1, 2, or 3; and Y is a straight or branched chain alkoxyalkyl group having 1 to 10 carbons, wherein the alkoxyalkyl group may be substituted at any position with a sulfonic acid group.

In an embodiment, R₁ is H and R₂ is other than H. In such an embodiment, the repeating unit is derived from a 3-substituted thiophene.

The polythiophene can be a regiorandom or a regioregular compound. Due to its asymmetrical structure, the polymerization of 3-substituted thiophenes produces a mixture of polythiophene structures containing three possible regiochemical linkages between repeat units. The three orientations available when two thiophene rings are joined are the 2,2'; 2,5', and 5,5' couplings. The 2,2' (or head-to-head) coupling and the 5,5' (or tail-to-tail) coupling are referred to as regiorandom couplings. In contrast, the 2,5' (or head-to-tail) coupling is referred to as a regioregular coupling. The degree of regioregularity can be, for example, about 0 to 100%, or about 25 to 99.9%, or about 50 to 98%. Regioregularity may be determined by standard methods known to those of ordinary skill in the art, such as, for example, using NMR spectroscopy.

In an embodiment, the polythiophene is regioregular. In an embodiment, the regioregularity of the polythiophene can be at least about 85%, typically at least about 95%, more typically at least about 98%. In an embodiment, the degree of regioregularity can be at least about 70%, typically at least about 80%. In yet other embodiments, the regioregular polythiophene has a degree of regioregularity of at least about 90%, typically a degree of regioregularity of at least about 98%.

3-substituted thiophene monomers, including polymers derived from such monomers, are commercially-available or may be made by methods known to those of ordinary skill in the art. Synthetic methods, doping, and polymer characterization, including regioregular polythiophenes with side groups, are provided in, for example, U.S. Patent No. 6,602,974 to McCullough et al. and U.S. Patent No. 6,166,172 to McCullough et al.

In another embodiment, R₁ and R₂ are both other than H. In such an embodiment, the repeating unit is derived from a 3,4-disubstituted thiophene.

In an embodiment, R₁ and R₂ are each, independently, -O[C(RₐR_{b})-C(R_{c}R_{d})-O]ₚ-Rₑ, or -OR_{f}; or R₁ and R₂ together form -O-(CH₂)_{q}-O-. In an embodiment, R₁ and R₂ are both -O[C(RₐR_{b})-C(R_{c}R_{d})-O]ₚ-Rₑ. R₁ and R₂ may be the same or different.

In an embodiment, each occurrence of Rₐ, R_{b}, R_{c}, and R_{d} is each, independently, H, (C₁-C₈) alkyl, (C₁-C₈) fluoroalkyl, or phenyl; and Rₑ is (C₁-C₈) alkyl, (C₁-C₈) fluoroalkyl, or phenyl.

In an embodiment, R₁ and R₂ are each -O[CH₂-CH₂-O]ₚ-R_{e.} In an embodiment, R₁ and R₂ are each -O[CH(CH₃)-CH₂-O]ₚ-R_{e.}

In an embodiment, Rₑ is methyl, propyl, or butyl.

In an embodiment, q is 2.

In an embodiment, -O-(CH₂)_{q}-O- is substituted at one or more positions with Y. In an embodiment, -O-(CH₂)_{q}-O- is substituted at one position with Y.

In an embodiment, q is 2 and Y is a 3-sulfobutoxymethyl group. In this case, the -O-(CH₂)₂-O- group is preferably substituted at one position with a 3-sulfobutoxymethyl group.

In an embodiment, the polythiophene comprises a repeating unit selected from the group consisting of 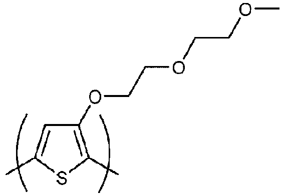 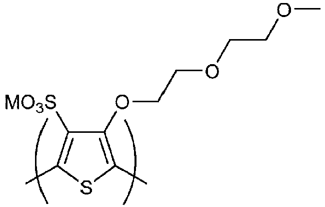 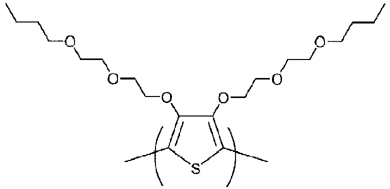 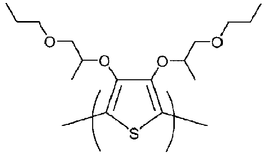 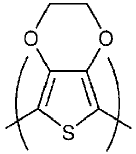 and combinations thereof, wherein M is H, an alkali metal, ammonium, a monoalkylammonium, a dialkylammonium, or a trialkylammonium.

It would be clear to the ordinarily-skilled artisan that the repeating unit 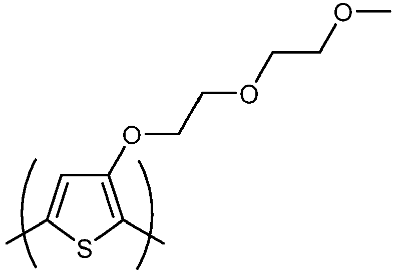 is derived from the monomer represented by the following structure: 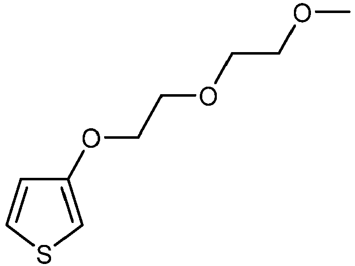 3-(2-(2-methoxyethoxy)ethoxy)thiophene [referred to herein as 3-MEET];
The repeating unit 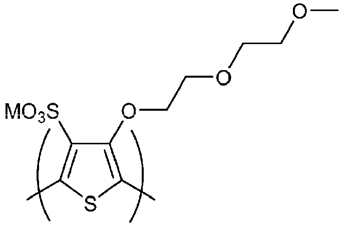 is derived from a monomer represented by the following structure: 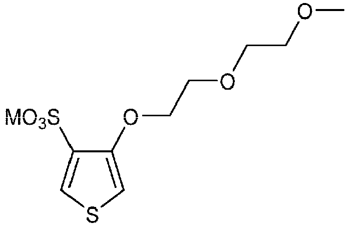 wherein M is H, an alkali metal, ammonium, a monoalkylammonium, a dialkylammonium, or a trialkylammonium;
Sulfonated 3 -(2-(2-methoxyethoxy)ethoxy)thiophene [referred to herein as sulfonated 3-MEET];
The repeating unit 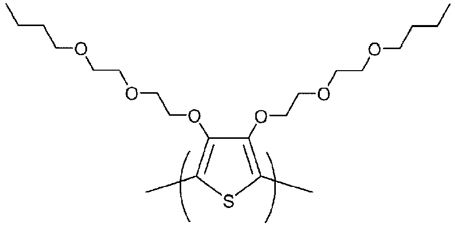 is derived from the monomer represented by the following structure: 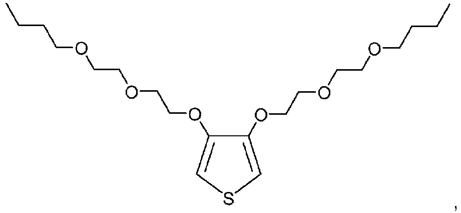 3,4-bis(2-(2-butoxyethoxy)ethoxy)thiophene [referred to herein as 3,4-diBEET];
The repeating unit 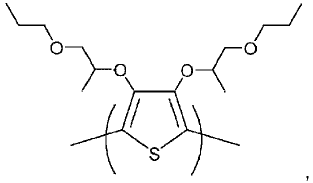 is derived from a monomer represented by the following structure: 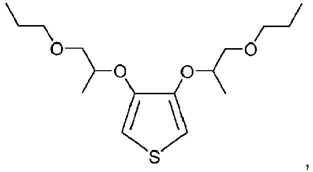 3,4-bis((1-propoxypropan-2-yl)oxy)thiophene [referred to herein as 3,4-diPPT]; and
The repeating unit 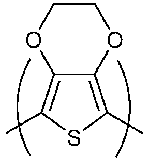 is derived from the monomer represented by the following structure: 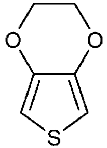 3,4-ethylenedioxythiophene.

3,4-disubstituted thiophene monomers, including polymers derived from such monomers, are commercially-available or may be made by methods known to those of ordinary skill in the art. For example, a 3,4-disubstituted thiophene monomer may be produced by reacting 3,4-dibromothiophene with a metal salt, typically the sodium salt, of a compound given by the formula HO-[Z-O]ₚ-Rₑ or HOR_{f}, wherein Z, Rₑ, R_{f} and p are as defined herein.

The polymerization of 3,4-disubstituted thiophene monomers may be carried out by, first, brominating the 2 and 5 positions of the 3,4-disubstituted thiophene monomer to form the corresponding 2,5-dibromo derivative of the 3,4-disubstituted thiophene monomer. The polymer can then be obtained by GRIM (Grignard methathesis) polymerization of the 2,5-dibromo derivative of the 3,4-disubstituted thiophene in the presence of a nickel catalyst. Such a method is described, for example, in US Patent 8,865,025, the entirety of which is hereby incorporated by reference. Another known method of polymerizing thiophene monomers is by oxidative polymerization using organic non-metal containing oxidants, such as 2,3-dichloro-5,6-dicyano-1,4-benzoquinone (DDQ), or using a transition metal halide, such as, for example, iron(III) chloride, molybdenum(V) chloride, and ruthenium(III) chloride, as an oxidizing agent.

Examples of compounds having the formula HO-[Z-O]ₚ-Rₑ or HOR_{f} that may be converted to a metal salt, typically a sodium salt, and used to produce 3,4-disubstituted thiophene monomers include, but are not limited to, trifluoroethanol, ethylene glycol monohexyl ether (hexyl Cellosolve), propylene glycol monobutyl ether (Dowanol™ PnB), diethylene glycol monoethyl ether (ethyl Carbitol), dipropylene glycol n-butyl ether (Dowanol™ DPnB), diethylene glycol monophenyl ether (phenyl Carbitol), ethylene glycol monobutyl ether (butyl Cellosolve), diethylene glycol monobutyl ether (butyl Carbitol), dipropylene glycol monomethyl ether (Dowanol™ DPM), diisobutyl carbinol, 2-ethylhexyl alcohol, methyl isobutyl carbinol, ethylene glycol monophenyl ether (Dowanol™ Eph), propylene glycol monopropyl ether (Dowanol™ PnP), propylene glycol monophenyl ether (Dowanol™ PPh), diethylene glycol monopropyl ether (propyl Carbitol), diethylene glycol monohexyl ether (hexyl Carbitol), 2-ethylhexyl carbitol, dipropylene glycol monopropyl ether (Dowanol™ DPnP), tripropylene glycol monomethyl ether (Dowanol™ TPM), diethylene glycol monomethyl ether (methyl Carbitol), and tripropylene glycol monobutyl ether (Dowanol™ TPnB).

The polythiophene having a repeating unit represented by formula (I) of the present disclosure may be further modified subsequent to its formation by polymerization. For instance, polythiophenes having one or more repeating units derived from 3-substituted thiophene monomers may possess one or more sites where a hydrogen may be replaced by a substituent, such as a sulfonic acid group (-SO₃H) by sulfonation.

As used herein, the term "sulfonated" in relation to a polythiophene means that the polythiophene comprises one or more sulfonic acid groups (-SO₃H). (Such polythiophene is also referred to as a "sulfonated polythiophene").

Typically, the sulfur atom of the -SO₃H group is directly bonded to the backbone of the polythiophene and not to a side group. For the purposes of the present disclosure, a side group is a monovalent radical that, when theoretically or actually removed from the polymer, does not shorten the length of the polymer chain. The sulfonated polythiophene polymer and/or copolymer may be made using any method known to those of ordinary skill in the art. For example, the polythiophene may be sulfonated by reaction with a sulfonating reagent such as, for example, fuming sulfuric acid, acetyl sulfate, pyridine SO₃, or the like. In another example, monomers may be sulfonated using a sulfonating reagent and then polymerized according to known methods and/or methods described herein. It would be understood by the ordinarily-skilled artisan that sulfonic acid groups in the presence of a basic compound, for example, alkali metal hydroxides, ammonia, and alkylamines, such as, for example, mono-, di-, and trialkylamines, such as, for example, triethylamine, may result in the formation of the corresponding salt or adduct. Thus, the term "sulfonated" in relation to the polythiophene includes the meaning that the polythiophene may comprise one or more -SO₃M groups, wherein M may be an alkali metal ion, such as, for example, Na⁺, Li⁺, K⁺, Rb⁺, Cs⁺; ammonium (NH₄⁺), mono-, di-, and trialkylammonium, such as triethylammonium.

The sulfonation of conjugated polymers and sulfonated conjugated polymers, including sulfonated polythiophenes, are described in U.S. Patent No. 8,017,241 to Seshadri et al., which is incorporated herein by reference in its entirety.

Also, sulfonated polythiophenes are described in WO 2008/073149 and WO 2016/171935, which are incorporated herein by reference in their entirety.

In an embodiment, the polythiophene is sulfonated.

In an embodiment, the sulfonated polythiophene comprises a repeating unit represented by formula (I) below: 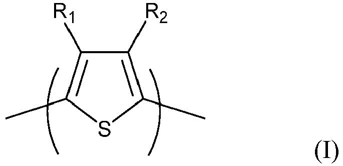 wherein R₁ and R₂ are each, independently, H, alkyl, fluoroalkyl, alkoxy, fluoroalkoxy, aryloxy, or -O-[Z-O]ₚ-Rₑ;
wherein
   Z is an optionally halogenated hydrocarbylene group,
   p is an integer equal to or greater than 1, and
   Rₑ is H, alkyl, fluoroalkyl, or aryl;
provided that either R₁ or R₂ is -SO₃M, wherein M is H, an alkali-metal, ammonium, a monoalkylammonium, a dialkylammonium, or a trialkylammonium.

In an embodiment, the sulfonated polythiophene comprises a repeating unit represented by formula (I), wherein R₁ and R₂ are each, independently, H, fluoroalkyl, -O[C(RₐR_{b})-C(R_{c}R_{d})-O]ₚ-Rₑ, or -OR_{f}; wherein each occurrence of Rₐ, R_{b}, R_{c}, and R_{d} is each, independently, H, halogen, alkyl, fluoroalkyl, or aryl; Rₑ is H, alkyl, fluoroalkyl, or aryl; p is 1, 2, or 3; and R_{f} is alkyl, fluoroalkyl, or aryl; provided that either R₁ or R₂ is -SO₃M, wherein M is H, an alkali-metal, ammonium, a monoalkylammonium, a dialkylammonium, or a trialkylammonium.

In an embodiment, R₁ is -SO₃M, wherein M is H, an alkali-metal, ammonium, a monoalkylammonium, a dialkylammonium, or a trialkylammonium; and R₂ is other than -SO₃M. M is preferably a monoalkylammonium, a dialkylammonium, or a trialkylammonium, more preferably a trialkylammonium.

In an embodiment, R₁ is -SO₃M and R₂ is -O[C(RₐR_{b})-C(R_{c}R_{d})-O]ₚ-Rₑ, or - OR_{f}.

In an embodiment, R₁ is -SO₃M and R₂ is -O[C(RₐR_{b})-C(R_{c}R_{d})-O]ₚ-Rₑ.

In an embodiment, R₁ is -SO₃M and R₂ is -O-CH₂CH₂-O-CH₂CH₂-O-CH₃.

In an embodiment, the sulfonated polythiophene is obtained by sulfonation of a polythiophene comprising a repeating unit represented by formula (I) below: 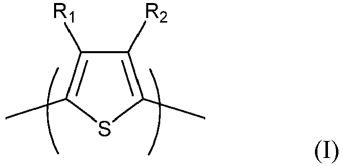 wherein R₁ and R₂ are each, independently, H, alkyl, fluoroalkyl, alkoxy, fluoroalkoxy, aryloxy, or -O-[Z-O]ₚ-Rₑ;
wherein
Z is an optionally halogenated hydrocarbylene group,
p is an integer equal to or greater than 1, and
Rₑ is H, alkyl, fluoroalkyl, or aryl;

In an embodiment, the sulfonated polythiophene is obtained by sulfonation of a polythiophene comprising a repeating unit represented by formula (I), wherein R₁ and R₂ are each, independently, H, fluoroalkyl, -O[C(RₐR_{b})-C(R_{c}R_{d})-O]ₚ-Rₑ, or -OR_{f}; wherein each occurrence of Rₐ, R_{b}, R_{c}, and R_{d} is each, independently, H, halogen, alkyl, fluoroalkyl, or aryl; Rₑ is H, alkyl, fluoroalkyl, or aryl; p is 1, 2, or 3; and R_{f} is alkyl, fluoroalkyl, or aryl.

In an embodiment, R₁ is H and R₂ is other than H. In such an embodiment, the repeating unit is derived from a 3-substituted thiophene.

The sulfonated polythiophene can be obtained from a polythiophene that can be a regiorandom or a regioregular compound. Due to its asymmetrical structure, the polymerization of 3-substituted thiophenes produces a mixture of polythiophene structures containing three possible regiochemical linkages between repeat units. The three orientations available when two thiophene rings are joined are the 2,2'; 2,5', and 5,5' couplings. The 2,2' (or head-to-head) coupling and the 5,5' (or tail-to-tail) coupling are referred to as regiorandom couplings. In contrast, the 2,5' (or head-to-tail) coupling is referred to as a regioregular coupling. The degree of regioregularity can be, for example, about 0 to 100%, or about 25 to 99.9%, or about 50 to 98%. Regioregularity may be determined by standard methods known to those of ordinary skill in the art, such as, for example, using NMR spectroscopy.

3-substituted thiophene monomers, including polymers derived from such monomers, are commercially-available or may be made by methods known to those of ordinary skill in the art. Synthetic methods, doping, and polymer characterization, including regioregular polythiophenes with side groups, are provided in, for example, U.S. Patent No. 6,602,974 to McCullough et al. and U.S. Patent No. 6,166,172 to McCullough et al. The sulfonation of conjugated polymers and sulfonated conjugated polymers, including sulfonated polythiophenes, are described in U.S. Patent No. 8,017,241 to Seshadri et al.

In an embodiment, R₁ is H and R₂ is -O[C(RₐR_{b})-C(R_{c}R_{d})-O]ₚ-Rₑ, or -OR_{f.} In an embodiment, R₁ is H and R₂ is -O[C(RₐR_{b})-C(R_{c}R_{d})-O]ₚ-Rₑ.

In an embodiment, each occurrence of Rₐ, R_{b}, R_{c}, and R_{d} is each, independently, H, (C₁-C₈) alkyl, (C₁-C₈) fluoroalkyl, or phenyl; and Rₑ and R_{f} are each, independently, H, (C₁-C₈) alkyl, (C₁-C₈) fluoroalkyl, or phenyl.

In an embodiment, R₂ is -O[CH₂-CH₂-O]ₚ-Rₑ. In an embodiment, R₂ is - OR_{f}.

Examples of compounds having the formula HO[C(RₐR_{b})-C(R_{c}R_{d})-O]ₚ-Rₑ or HOR_{f} that may be converted to a metal salt, typically a sodium salt, and linked to the thiophene monomers to form 3-substituted thiophenes that are then used to produce the polythiophene to be sulfonated include, but are not limited to, trifluoroethanol, ethylene glycol monohexyl ether (hexyl Cellosolve), propylene glycol monobutyl ether (Dowanol™ PnB), diethylene glycol monoethyl ether (ethyl Carbitol), dipropylene glycol n-butyl ether (Dowanol™ DPnB), diethylene glycol monophenyl ether (phenyl Carbitol), ethylene glycol monobutyl ether (butyl Cellosolve), diethylene glycol monobutyl ether (butyl Carbitol), dipropylene glycol monomethyl ether (Dowanol™ DPM), diisobutyl carbinol, 2-ethylhexyl alcohol, methyl isobutyl carbinol, ethylene glycol monophenyl ether (Dowanol™ Eph), propylene glycol monopropyl ether (Dowanol™ PnP), propylene glycol monophenyl ether (Dowanol™ PPh), diethylene glycol monopropyl ether (propyl Carbitol), diethylene glycol monohexyl ether (hexyl Carbitol), 2-ethylhexyl carbitol, dipropylene glycol monopropyl ether (Dowanol™ DPnP), tripropylene glycol monomethyl ether (Dowanol™ TPM), diethylene glycol monomethyl ether (methyl Carbitol), and tripropylene glycol monobutyl ether (Dowanol™ TPnB).

In an embodiment, Rₑ is H, methyl, propyl, or butyl. In an embodiment, R_{f} is -CH₂CF₃.

In an embodiment, the sulfonated polythiophene is obtained by sulfonation of a polythiophene that comprises the repeating unit represented by the following formula:

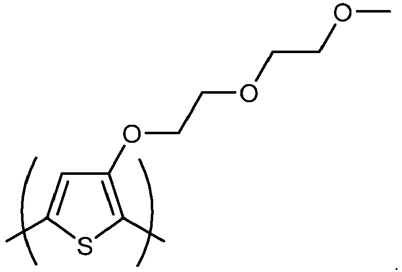

It would be clear to the ordinarily-skilled artisan that the repeating unit represented by the following formula: 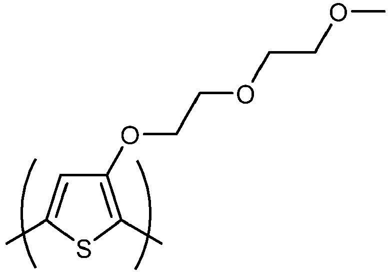 is derived from a monomer represented by the structure represented by the following formula: 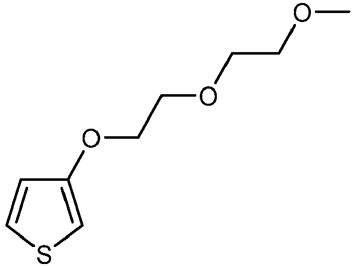 3-(2-(2-methoxyethoxy)ethoxy)thiophene [referred to herein as 3-MEET].

Accordingly, sulfonation of a polythiophene comprising the repeating unit represented by the following formula results in sulfonated poly(3-MEET).

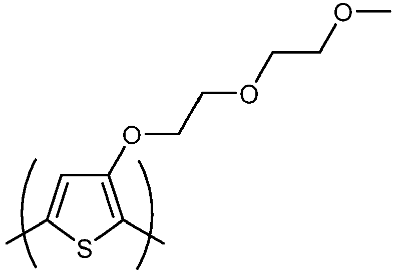

In an embodiment, the polythiophene is sulfonated poly(3-MEET).

The polythiophenes used according to the present disclosure may be homopolymers or copolymers, including statistical, random, gradient, and block copolymers. For a polymer comprising a monomer A and a monomer B, block copolymers include, for example, A-B diblock copolymers, A-B-A triblock copolymers, and -(AB)ₖ-multiblock copolymers. The polythiophene may comprise repeating units derived from other types of monomers such as, for example, thienothiophenes, selenophenes, pyrroles, furans, tellurophenes, anilines, arylamines, and arylenes, such as, for example, phenylenes, phenylene vinylenes, and fluorenes.

In an embodiment, the polythiophene comprises repeating units represented by formula (I) in an amount of greater than 50% by weight, typically greater than 80% by weight, more typically greater than 90% by weight, even more typically greater than 95% by weight, based on the total weight of the repeating units.

It would be clear to a person of ordinary skill in the art that, depending on the purity of the starting monomer compound(s) used in the polymerization, the polymer formed may contain repeating units derived from impurities. As used herein, the term "homopolymer" is intended to mean a polymer comprising repeating units derived from one type of monomer, but may contain repeating units derived from impurities. In an embodiment, the polythiophene is a homopolymer wherein essentially all of the repeating units are repeating units represented by formula (I).

The polythiophene typically has a number average molecular weight between about 1,000 and 1,000,000 g/mol. More typically, the conjugated polymer has a number average molecular weight between about 5,000 and 100,000 g/mol, even more typically about 10,000 to about 50,000 g/mol. Number average molecular weight may be determined according to methods known to those of ordinary skill in the art, such as, for example, by gel permeation chromatography.

In an embodiment, the polythiophene is used after treatment with a reducing agent.

In conjugated polymers such as polythiophenes, the chemical structure of some of the repeating units constituting them may assume an oxidized structure called a "quinoid structure." The term "quinoid structure" is used as opposed to the term "benzenoid structure"; whereas the latter is a structure comprising an aromatic ring, the former refers to a structure in which double bond(s) in the aromatic ring have moved out of the ring (as a result of which the aromatic ring disappears), thereby forming two double bonds outside the ring that are conjugated to the other double bond(s) remaining in the ring. Those skilled in the art will readily appreciate the relationship between these two structures from the relationship between the structures of benzoquinone and hydroquinone. The quinoid structures for the repeating units of various conjugated polymers are well known to those skilled in the art. The quinoid structure corresponding to the repeating unit of the polythiophene represented by formula (I) above is shown in the following formula (I'). 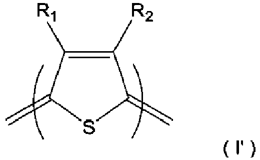 wherein R₁ and R₂ are as defined in formula (I).

This quinoid structure forms part of the structures called the "polaron structure" and the "bipolaron structure," which are generated by the doping reaction described above and impart charge transportability to conjugated polymers such as polythiophenes. These structures are known in the art. The introduction of the "polaron structure" and/or the "bipolaron structure" is essential in the fabrication of an organic EL device, and in fact, this is achieved by intentionally causing the above-mentioned doping reaction to occur when the charge transporting film formed from a charge transporting varnish is baked during the fabrication of an organic EL device. The presence of the quinoid structure in conjugated polymers observed before the doping reaction is caused to occur is believed to be attributable to an unintended oxidation reaction that is equivalent to the doping reaction and is undergone by the conjugated polymers in the manufacturing process thereof (in particular, the sulfonation step, in the case of sulfonating conjugated polymers).

There is a correlation between the amount of quinoid structure contained in a polythiophene and the dispersibility of the polythiophene in an organic solvent; as the amount of quinoid structure increases, the dispersibility decreases. Therefore, whereas the introduction of a quinoid structure after the formation of a charge transporting film from the ink composition does not cause a problem, if an excess amount of quinoid structure is introduced into the polythiophene by the above-mentioned unintended oxidation reaction, it negatively affects the production of the ink composition. It is known that the dispersibility of polythiophenes in organic solvents may vary from product to product, and it is believed that one of the reasons for this is because the amount of quinoid structure introduced into the polythiophene by the unintentional oxidation reaction discussed above varies depending on the difference in the production conditions for each polythiophene.

Accordingly, subjecting the polythiophene to reduction treatment using a reducing agent decreases, through reduction, the amount of quinoid structure, even if there was excessive quinoid structure introduced in the polythiophene at first. This improves the dispersibility of the polythiophene in an organic solvent, thereby allowing for consistent production of a good ink composition that gives a charge transporting film having excellent homogeneity.

The reducing agent used in this reduction treatment is not particularly limited as long as it can reduce the quinoid structure in the polythiophene, represented by formula (I') above, and thereby covert it into a non-oxidized structure, i.e., the benzenoid structure in the polythiophene, represented by formula (I) above, and for example, ammonia water, hydrazine, or the like are preferably used. The amount of reducing agent is typically from 0.1 to 10 parts by weight, preferably from 0.5 to 2 parts by weight, based on 100 parts by weight of the polythiophene to be treated.

There are no particular restrictions on the method and conditions for the reduction treatment. This treatment can be carried out, for example, simply by bringing the polythiophene into contact with a reducing agent in the presence or absence of a suitable solvent. Typically, reduction treatment under relatively mild conditions, such as stirring the polythiophene in 28% aqueous ammonia (e.g., overnight at room temperature), substantially improves the dispersibility of the polythiophene in an organic solvent.

If the polythiophene is sulfonated, the sulfonated polythiophene, if necessary, may be converted to a corresponding ammonium salt, e.g., a trialkylammonium salt (an amine adduct of the sulfonated polythiophene) prior to subjecting it to reduction treatment.

A polythiophene that was not dissolved in the reaction system at the start of the treatment may be dissolved at the completion of the treatment, as a result of a change in the dispersibility of the polythiophene in the solvent caused by the reduction treatment. In such cases, the polythiophene can be recovered, for example, by adding an organic solvent incompatible with the polythiophene (such as acetone, isopropyl alcohol, etc.) to the reaction system to cause precipitation of the polythiophene before subjecting it to filtration.

The ink composition of the present disclosure may optionally further comprise other hole carrier compounds.

Optional hole carrier compounds include, for example, low molecular weight compounds or high molecular weight compounds. The optional hole carrier compounds may be non-polymeric or polymeric. Non-polymeric hole carrier compounds include, but are not limited to, cross-linkable and non-crosslinked small molecules. Examples of non-polymeric hole carrier compounds include, but are not limited to, N,N'-bis(3-methylphenyl)-N,N'-bis(phenyl)benzidine (CAS # 65181-78-4); N,N'-bis(4-methylphenyl)-N,N'-bis(phenyl)benzidine; N,N'-bis(2-naphtalenyl)-N-N'-bis(phenylbenzidine) (CAS # 139255-17-1); 1,3,5-tris(3-methyldiphenylamino)benzene (also referred to as m-MTDAB); N,N'-bis(1-naphtalenyl)-N,N'-bis(phenyl)benzidine (CAS # 123847-85-8, NPB); 4,4',4"-tris(N,N-phenyl-3-methylphenylamino)triphenylamine (also referred to as m-MTDATA, CAS # 124729-98-2); 4,4',N,N'-diphenylcarbazole (also referred to as CBP, CAS # 58328-31-7); 1,3,5-tris(diphenylamino)benzene; 1,3,5-tris(2-(9-ethylcarbazyl-3)ethylene)benzene; 1,3,5-tris[(3-methylphenyl)phenylamino]benzene; 1,3-bis(N-carbazolyl)benzene; 1,4-bis(diphenylamino)benzene; 4,4'-bis(N-carbazolyl)-1,1'-biphenyl; 4,4'-bis(N-carbazolyl)-1,1'-biphenyl; 4-(dibenzylamino)benzaldehyde-N,N-diphenylhydrazone; 4-(diethylamino)benzaldehyde diphenylhydrazone; 4-(dimethylamino)benzaldehyde diphenylhydrazone; 4-(diphenylamino)benzaldehyde diphenylhydrazone; 9-ethyl-3-carbazolecarboxaldehyde diphenylhydrazone; copper(II) phthalocyanine; N,N'-bis(3-methylphenyl)-N,N'-diphenylbenzidine; N,N'-di-[(1-naphthyl)-N,N'-diphenyl]-1,1'-biphenyl)-4,4'-diamine; N,N'-diphenyl-N,N'-di-p-tolylbenzene-1,4-diamine; tetra-N-phenylbenzidine; titanyl phthalocyanine; tri-p-tolylamine; tris(4-carbazol-9-ylphenyl)amine; and tris[4-(diethylamino)phenyl]amine.

Optional polymeric hole carrier compounds include, but are not limited to, poly[(9,9-dihexylfluorenyl-2,7-diyl)-alt-co-(N,N'-bis{p-butylphenyl}-1,4-diaminophenylene)]; poly[(9,9-dioctylfluorenyl-2,7-diyl)-alt-co-(N,N'-bis{p-butylphenyl}-1,1'-biphenylene-4,4'-diamine)]; poly(9,9-dioctylfluorene-co-N-(4-butylphenyl)diphenylamine) (also referred to as TFB) and poly[N,N'-bis(4-butylphenyl)-N,N'-bis(phenyl)-benzidine] (commonly referred to as poly-TPD).

Other optional hole carrier compounds are described in, for example, US Patent Publications 2010/0292399 published Nov. 18, 2010; 2010/010900 published May 6, 2010; and 2010/0108954 published May 6, 2010. Optional hole carrier compounds described herein are known in the art and are commercially available.

The polythiophene comprising a repeating unit complying with formula (I) may be doped or undoped.

In an embodiment, the polythiophene comprising a repeating unit complying with formula (I) is doped with a dopant. Dopants are known in the art. See, for example, U.S. Patent 7,070,867; US Publication 2005/0123793; and US Publication 2004/0113127. The dopant can be an ionic compound. The dopant can comprise a cation and an anion. One or more dopants may be used to dope the polythiophene comprising a repeating unit complying with formula (I).

The cation of the ionic compound can be, for example, V, Cr, Mn, Fe, Co, Ni, Cu, Nb, Mo, Tc, Ru, Rh, Pd, Ag, Ta, W, Re, Os, Ir, Pt, or Au.

The cation of the ionic compound can be, for example, gold, molybdenum, rhenium, iron, and silver cation.

In some embodiments, the dopant can comprise a sulfonate or a carboxylate, including alkyl, aryl, and heteroaryl sulfonates and carboxylates. As used herein, "sulfonate" refers to a -SO₃M group, wherein M may be H⁺ or an alkali metal ion, such as, for example, Na⁺, Li⁺, K⁺, Rb⁺, Cs⁺; or ammonium (NH₄⁺). As used herein, "carboxylate" refers to a -CO₂M group, wherein M may be H⁺ or an alkali metal ion, such as, for example, Na⁺, Li⁺, K⁺, Rb⁺, Cs⁺; or ammonium (NH₄⁺). Examples of sulfonate and carboxylate dopants include, but are not limited to, benzoate compounds, heptafluorobutyrate, methanesulfonate, trifluoromethanesulfonate, p-toluenesulfonate, pentafluoropropionate, and polymeric sulfonates, perfluorosulfonate-containing ionomers, and the like.

In some embodiments, the dopant does not comprise a sulfonate or a carboxylate.

In some embodiments, dopants may comprise sulfonylimides, such as, for example, bis(trifluoromethanesulfonyl)imide; antimonates, such as, for example, hexafluoroantimonate; arsenates, such as, for example, hexafluoroarsenate; phosphorus compounds, such as, for example, hexafluorophosphate; and borates, such as, for example, tetrafluoroborate, tetraarylborates, and trifluoroborates. Examples of tetraarylborates include, but are not limited to, halogenatedtetraarylborates, such as tetrakispentafluorophenylborate (TPFB). Examples of trifluoroborates include, but are not limited to, (2-nitrophenyl)trifluoroborate, benzofurazan-5-trifluoroborate, pyrimidine-5-trifluoroborate, pyridine-3-trifluoroborate, and 2,5-dimethylthiophene-3-trifluoroborate.

As described herein, the polythiophene may be doped with a dopant. The dopant can be, for example, a material that will undergo, for example, one or more electron transfer reaction(s) with a polythiophene, thereby yielding a doped polythiophene. The dopant can be selected to provide a suitable charge balancing counter-anion. A reaction can occur upon mixing of the polythiophene and the dopant as known in the art. For example, the dopant may undergo spontaneous electron transfer from the polymer to a cation-anion dopant, such as a metal salt, leaving behind a conjugated polymer in its oxidized form with an associated anion and free metal. See, for example, Lebedev et al., Chem. Mater., 1998, 10, 156-163. As disclosed herein, the polythiophene and the dopant can refer to components that will react to form a doped polymer. The doping reaction can be a charge transfer reaction, wherein charge carriers are generated, and the reaction can be reversible or irreversible. In some embodiments, silver ions may undergo electron transfer to or from silver metal and the doped polymer.

In the final formulation, the composition can be distinctly different from the combination of original components (i.e., polythiophene and/or dopant may or may not be present in the final composition in the same form as before mixing).

Some embodiments allow for removal of reaction by-products from the doping process. For example, the metals, such as silver, can be removed by filtration.

Materials can be purified to remove, for example, halogens and metals. Halogens include, for example, chloride, bromide and iodide. Metals include, for example, the cation of the dopant, including the reduced form of the cation of the dopant, or metals left from catalyst or initiator residues. Metals include, for example, silver, nickel, and magnesium. The amounts can be less than, for example, 100 ppm, or less than 10 ppm, or less than 1 ppm.

Metal content, including silver content, can be measured by ICP-MS, particularly for concentrations greater than 50 ppm.

In an embodiment, when the polythiophene is doped with a dopant, the polythiophene and the dopant are mixed to form a doped polymer composition. Mixing may be achieved using any method known to those of ordinary skill in the art. For example, a solution comprising the polythiophene may be mixed with a separate solution comprising the dopant. The solvent or solvents used to dissolve the polythiophene and the dopant may be one or more solvents described herein. A reaction can occur upon mixing of the polythiophene and the dopant as known in the art. The resulting doped polythiophene composition comprises between about 40% and 75% by weight of the polymer and between about 25% and 55% by weight of the dopant, based on the composition. In another embodiment, the doped polythiophene composition comprises between about 50% and 65% for the polythiophene and between about 35% and 50% of the dopant, based on the composition. Typically, the amount by weight of the polythiophene is greater than the amount by weight of the dopant. Typically, the dopant can be a silver salt, such as silver tetrakis(pentafluorophenyl)borate in an amount of about 0.25 to 0.5 m/ru, wherein m is the molar amount of silver salt and ru is the molar amount of polymer repeat unit.

The doped polythiophene is isolated according to methods known to those of ordinary skill in the art, such as, for example, by rotary evaporation of the solvent, to obtain a dry or substantially dry material, such as a powder. The amount of residual solvent can be, for example, 10 wt. % or less, or 5 wt. % or less, or 1 wt. % or less, based on the dry or substantially dry material. The dry or substantially dry powder can be redispersed or redissolved in one or more new solvents.

The ink composition of the present invention comprises one or more metal oxide nanoparticles (b). A "nanoparticle" refers to a fine particle having a primary particle average diameter on the order of nanometers (typically, 500 nm or less). A "metal oxide nanoparticle" refers to an oxide of a metal formed into a nanoparticle.

Metals for the metal oxide nanoparticles (b) include metalloids in addition to metals in the usual sense. Metals in the usual sense may be used alone or in combination of two or more, and those used preferably include, but are not limited to, at least one selected from the group consisting of tin (Sn), titanium (Ti), aluminum (Al), zirconium (Zr), zinc (Zn), niobium (Nb), tantalum (Ta), and W (tungsten).

By contrast, a "metalloid" refers to a chemical element that has chemical and/or physical properties in between those of metals and nonmetals. Although no universal definition of metalloids has been established, in the present invention, the term "metalloid" refers to the following six elements: boron (B), silicon (Si), germanium (Ge), arsenic (As), antimony (Sb), and tellurium (Te). These metalloids may be used alone or in combination of two or more, or may be used in combination with a metal in the usual sense.

The metal oxide nanoparticles (b) preferably comprise an oxide of at least one metal selected from the group consisting of boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta), and W (tungsten). When the metal is a combination of two or more metals, the metal oxide may be a mixture of oxides of individual single metals or may be a composite oxide comprising a plurality of metals. Specific examples of metal oxides include, but are not limited to B₂O₃, B₂O, SiO₂, SiO, GeO₂, GeO, As₂O₄, As₂O₃, As₂O₅, Sb₂O₃, Sb₂O₅, TeO₂, SnO₂, ZrO₂, Al₂O₃, ZnO and the like.

In an embodiment, the metal oxide nanoparticles (b) comprise B₂O₃, B₂O, SiO₂, SiO, GeO₂, GeO, As₂O₄, As₂O₃, As₂O₅, SnO₂, SnO, Sb₂O₃, TeO₂, or mixtures thereof. In another embodiment, the metal oxide nanoparticles (b) comprise SiO₂.

The metal oxide nanoparticles have a primary particle average diameter typically in the range of 1 nm or greater and 500 nm or less, preferably 1 nm or greater and 250 nm or less, more preferably about 1 nm or greater and about 100 nm or less, still more preferably 1 nm or greater and 50 nm or less, particularly preferably about 2 nm or greater and about 30 nm or less, and most preferably 3 nm or greater and 25 nm or less. Examples of methods for measuring the average particle diameter of primary particles include, for example, a method using a transmission electron microscope (TEM), a method of calculation based on the specific surface area obtained by the BET method, and the like.

Various methods are known in the art for measuring the average particle diameter that involve the use of TEM, and one example thereof is a method based on circle equivalent diameters. In this method, a projected image of particles obtained by using a TEM (e.g., the transmission electron microscope HT7700, manufactured by Hitachi High Technologies Corporation) is processed by image processing software to determine the circle equivalent diameters of the individual particles, and the average particle diameter is calculated as the number average of these circle equivalent diameters. The circle equivalent diameter is also called the Haywood diameter, and is the diameter of a circle having the same area as that of a projected image of a particle. In this method, projection images are typically processed using the image processing software provided with a TEM and created by the TEM manufacturer.

The metal oxide nanoparticles (b) may comprise one or more organic capping groups. Such organic capping groups may be reactive or non-reactive. Examples of reactive organic capping groups include organic capping groups that can be cross-linked by ultraviolet light or a radical initiator. In an embodiment, the metal oxide nanoparticles (b) comprise one or more organic capping groups.

The metal oxide nanoparticles (b) may comprise one or more organic capping groups, but in view of compatibility with the organic solvents of the present invention, metal oxide nanoparticles that are not organically capped, i.e., not surface treated, are preferred.

The metal oxide nanoparticles (b) can be produced by methods known in the art, but are also available as commercial products. Commercially available metal oxide nanoparticles are typically in the form of a dispersion. Preferably, a non-aqueous dispersion of metal oxide nanoparticles that is commercially available is used. Examples of suitable commercially available metal oxide nanoparticles include ORGANOSILICASOL™ products, manufactured by Nissan Chemical Industries, Ltd., which are non-aqueous dispersions in which SiO₂ nanoparticles are dispersed in various solvents, such as, for example, methanol, methyl ethyl ketone, methyl isobutyl ketone, N,N-dimethylacetamide, ethylene glycol, isopropanol, methanol, ethylene glycol monopropyl ether, cyclohexanone, ethyl acetate, toluene, and propylene glycol monomethyl ether acetate.

The amount of the metal oxide nanoparticles (b) in the ink composition of the present invention is expressed as a weight percentage relative to the combined weight of the metal oxide nanoparticles (b) and the charge transporting material (a) (including doped and undoped forms). The amount of the metal oxide nanoparticles (b) is typically from about 1 wt. % to about 98 wt. %, preferably from about 2 wt. % to about 95 wt. %, more preferably from about 5 wt. % to about 90 wt. %, still more preferably about 10 wt. % to about 90 wt. %, relative to the combined weight of the metal oxide nanoparticles (b) and the charge transporting material (a). In an embodiment, the amount of the metal oxide nanoparticles (b) is from about 20 wt. % to about 98 wt. %, preferably from about 25 wt. to about 95 wt. %, relative to the combined weight of the metal oxide nanoparticles (b) and the charge transporting material (a).

The ink composition of the present invention comprises a liquid carrier (c) of a certain composition. The composition of the liquid carrier (c) is important in the present invention. This composition will be described in more detail below.

As described above, when an ink composition is applied to a substrate by an ink jetting method to form a charge transporting film, the pile-up phenomenon may cause the charge transporting film obtained to have non-uniform thickness, even if a substrate having a liquid repellent bank is used as the substrate. The present inventors have discovered that an ink composition comprising metal oxide nanoparticles is particularly prone to this kind of pile-up phenomenon. Although the cause for this has not been elucidated, it is believed that the pile-up phenomenon occurs because certain interactions with other components in the composition, the substrate surface or the side of the bank cause the metal oxide nanoparticles dispersed in the ink composition to migrate to the side of the bank and proceed to climb along the bank during the drying process.

This prompted the present inventors to examine the relationship between the behavior of the metal oxide nanoparticles in the ink composition and the pile-up phenomenon, which led to the discovery that the more uniform the state of dispersion of the metal oxide nanoparticles in the ink composition, the more pronounced the occurrence of the pile-up phenomenon; that is, there is a correlation between the state of dispersion of the metal oxide nanoparticles in the ink composition and the occurrence of the pile-up phenomenon. This suggests that the pile-up phenomenon can be suppressed by suitably controlling the state of dispersion.

The state of dispersion of the metal oxide nanoparticles in the ink composition is affected by the composition of the liquid carrier used. This led to the conjecture that selecting a specific composition for the liquid carrier would enable the state of dispersion to be suitably controlled, especially during the process of volatilizing the liquid carrier, thereby suppressing the pile-up phenomenon.

Based on their relative degree of compatibility with metal oxide nanoparticles, organic solvents can be classified into those with high compatibility (hereafter referred to as "high compatibility solvents") and those with low compatibility (hereafter referred to as "low compatibility solvents"). Metal oxide nanoparticles disperse uniformly throughout the solvent if they are in a high compatibility solvent, but they assume a heterogeneous dispersion state in a low compatibility solvent, with a degree of aggregation depending on its compatibility with the metal oxide nanoparticles. In a mixture of a high compatibility solvent and a low compatibility solvent, the state of dispersion is somewhere in between them and varies depending on the ratio of the amount of the high compatibility solvent to the amount of the low compatibility solvent in the solvent.

At the same time, when an ink composition comprising a liquid carrier consisting of a mixture of a plurality of solvents is applied to a substrate and the liquid carrier volatilizes, the solvents having lower boiling points are naturally the first to volatilize. Therefore, as the volatilization progresses, the composition of the liquid carrier that remains in the liquid state will change. If the liquid carrier comprises a high compatibility solvent and a low compatibility solvent, the ratio between the amounts of these solvents in the remaining liquid carrier will change during the volatilization process, and the state of dispersion of the metal oxide nanoparticles will change accordingly. Therefore, it is possible to control the state of dispersion of the metal oxide nanoparticles in the liquid carrier and suppress the pile-up phenomenon by selecting a combination of solvents having suitable boiling points and suitable compatibility with the metal oxide nanoparticles and by suitably controlling the composition of the liquid carrier that remains.

If all the low compatibility solvents are volatilized first in the volatilization process and only the high compatibility solvents remain until the end, the metal oxide nanoparticles are uniformly dispersed throughout the ink composition without aggregation until the final stage of the volatilization process, making it easier to obtain a homogeneous charge transporting film. However, if, for example, the method for forming a film using a bank described above is adopted, the amount of metal oxide nanoparticles that migrate to the vicinity of the bank is relatively large, which tends to cause the pile-up phenomenon and makes it difficult to obtain a flat charge transporting film.

By contrast, if all the high compatibility solvents are volatilized first and only the low compatibility solvents remain until the end, the state of dispersion of the metal oxide nanoparticles becomes uneven at the final stage of the volatilization process, and the amount of metal oxide nanoparticles that migrate to the vicinity of the bank becomes relatively small, thereby suppressing the pile-up phenomenon and making it easier to obtain a flat charge transporting film. However, this results in excessive aggregation of metal oxide nanoparticles, which makes it difficult to obtain a homogeneous charge transporting film.

Therefore, in order to properly form a charge transporting film, it is desirable that at the final stage of the process of liquid carrier volatilization, the metal oxide nanoparticles be somewhere between these states of dispersion described above, i.e., in a state of dispersion that is not completely homogeneous, with a certain amount of aggregation.

As a result of extensive research, the present inventors found that, in order to suppress the pile-up phenomenon and enable the formation of a film that ensures flatness, it is effective to use a liquid carrier comprising a combination of a low compatibility solvent with a first high compatibility solvent having a boiling point lower than that of the low compatibility solvent, and a small amount of a second high compatibility solvent having a boiling point higher than that of the low compatibility solvent.

As described above, at the final stage of the process of liquid carrier volatilization, it is preferable for the metal oxide nanoparticles to be in a state of dispersion that is not completely homogeneous, with moderate aggregation. Such a state of dispersion is achieved when the metal oxide nanoparticles are dispersed in a liquid carrier comprising a low compatibility solvent that comprises small amounts of high compatibility solvents. If a liquid carrier of such a composition is used, most of the first high compatibility solvent volatilizes first during the process of liquid carrier volatilization, and as a result, the remaining liquid carrier will be of a composition in which a small amount of the first high compatibility solvent along with a small amount of the second high compatibility solvent is contained in the low compatibility solvent, and this composition results in a favorable state of dispersion of the metal oxide nanoparticles, with moderate aggregation. Even after the volatilization progresses and all of the first high compatibility solvent is volatilized, the second high compatibility solvent, which has a boiling point higher than that of the low compatibility solvent, remains until the final stage of the volatilization process, thereby maintaining the composition in which a small amount of the second high compatibility solvent is contained in the low compatibility solvent, until most of the low compatibility solvent is volatilized. As a result, the favorable state of dispersion described above is maintained until the volatilization progresses further and the amount of remaining liquid carrier becomes small enough not to cause the problem of the pile-up phenomenon.

Also, as described above, if an attempt is made to suppress the pile-up phenomenon without using a liquid carrier of a specific composition such as those described above, certain characteristics of the organic EL device may tend to deteriorate. However, the present inventors have demonstrated that when a charge transporting film is formed using the ink composition of the present invention, which comprises the liquid carrier described above, and used to fabricate an organic EL device, the deterioration in the characteristics of the resulting organic EL device, surprisingly, is less pronounced than when a conventional liquid carrier is used, and in particular, it suppresses the reduction in current efficiency.

Thus, using metal oxide nanoparticles in combination with a liquid carrier of a specific composition allows the pile-up phenomenon to be suppressed while avoiding excessive degradation in the characteristics of the organic EL device. As described above, a non-uniform thickness of the charge transporting film caused by the pile-up phenomenon may shorten the lifetime of an organic EL device, and this suppression of the pile-up phenomenon enables the lifetime of the organic EL device to be extended.

The liquid carrier used in the ink composition of the present invention comprises:
(c-1) a first hydrophilic glycol-based solvent having a boiling point of bp¹ (°C),
(c-2) a second hydrophilic glycol-based solvent having a boiling point of bp² (°C), and
(c-3) an organic solvent having a boiling point of bp³ (°C).
The solvent (c-3) corresponds to the low compatibility solvent described above, the solvent (c-1) has a boiling point lower than that of the solvent (c-3) and corresponds to the first high compatibility solvent described above, and the solvent (c-2) has a boiling point higher than that of the solvent (c-3) and corresponds to the second high compatibility solvent described above. Therefore, the boiling points bp¹, bp² and bp³ satisfy the relationship bp¹ < bp³ < bp². In view of process compatibility and film formability, it is more preferable that bp¹, bp², and bp³ are, respectively, 180°C or higher; 270°C or higher and 200°C or higher; and lower than 270°C,

To the extent that the conditions above are satisfied, bp¹ and bp³ preferably have a difference of 20°C or larger, bp² and bp³ preferably have a difference of 10°C or larger, and bp¹ and bp² preferably have a difference of 70°C or larger. Furthermore, it is more preferable to use, for the solvent (c-3), a combination of two solvents with a difference in bp³ of 20°C or more.

In a certain embodiment, bp¹ is 180°C or higher, bp² is 270°C or higher, and bp³ is 200°C or higher, and lower than 270°C.

Hydrophilic glycol-based solvents are used for the solvents (c-1) and (c-2) above. First, glycol-based solvents, which include these hydrophilic glycol-based solvents, will be described.

The term "glycol," in its broad sense, is a generic term for organic compounds having two alcoholic hydroxyl groups, but in the present invention, a "glycol-based solvent" means an organic solvent having the chemical structure represented by formula (y) below:

R¹-O-(R-O)ₙ-R² (y)

wherein
each R is, independently, a linear, branched, or cyclic, unsubstituted alkylene group having two or more carbons;
R¹ and R² are each, independently, a hydrogen atom, a linear, branched, or cyclic, unsubstituted alkyl group having one or more carbons, or a linear or branched, unsubstituted aliphatic acyl group having two or more carbons; and
n is an integer greater than or equal to 1.

In formula (y) above, each R is not particularly limited as long as it gives a glycol-based solvent that is liquid under the conditions of use and can be volatilized in the end, but is preferably each, independently, a linear C₂-C₄ unsubstituted alkylene group; R¹ and R² are not particularly limited as long as they give a glycol-based solvent that is liquid under the conditions of use and can be volatilized in the end, but are preferably each, independently, a hydrogen atom, a linear, branched or cyclic Ci-Cs unsubstituted alkyl group, or a linear or branched C₁-C₈ unsubstituted aliphatic acyl group; and n is preferably an integer from 1 to 6. It is particularly preferable that R above is a C₂ or C₃ unsubstituted alkylene group. It is also particularly preferable that n above is an integer from 1 to 4.

As for the alkyl groups above, linear, branched or cyclic C₁-C₆ unsubstituted alkyl groups are preferable, linear C₁-C₄ unsubstituted alkyl groups are more preferable, and methyl and n-butyl groups are particularly preferable.

As the acyl groups above, linear or branched C₂-C₆ unsubstituted aliphatic acyl groups are preferable, linear C₂-C₄ unsubstituted acyl groups are more preferable, and acetyl and propionyl groups are particularly preferable.

Ink compositions comprising a liquid carrier comprising such glycol-based solvents are particularly suitable for application by the inkjet method.

Among the glycol-based solvents above, organic solvents with a chemical structure in which R¹ and R² in formula (y) above are both hydrogen atoms are referred to as "glycol solvents" in the present invention.

Examples of glycol solvents include, but are not limited to, ethylene glycol, propylene glycol and oligomers thereof (dimers to tetramers, e.g., diethylene glycol).

Among the glycol-based solvents above, organic solvents with a chemical structure in which either one of R¹ and R² in formula (y) above is a hydrogen atom and the other one is an unsubstituted alkyl group are referred to as "glycol monoether solvents" in the present invention. Glycol monoether solvents correspond to monoalkyl ethers of the glycol solvents described above.

Examples of glycol monoether solvents include, but are not limited to, ethylene glycol monopropyl ether, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), ethylene glycol monobutyl ether (butyl Cellosolve), diethylene glycol monobutyl ether (butyl Carbitol), diethylene glycol monoisobutyl ether, dipropylene glycol monomethyl ether (Dowanol DPM), propylene glycol monopropyl ether (Dowanol PnP), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

Among the glycol-based solvents above, organic solvents with a chemical structure in which R¹ and R² in formula (y) above are both unsubstituted alkyl groups are referred to as "glycol diether solvents" in the present invention. Glycol diether solvents correspond to dialkyl ethers of the glycol solvents described above.

Examples of glycol diether solvents include, but are not limited to, ethylene glycol diethers such as 1,2-dimethoxyethane, 1,2-diethoxyethane, and 1,2-dibutoxyethane; diethylene glycol diethers such as diethylene glycol dimethyl ether, and diethylene glycol diethyl ether; propylene glycol diethers such as propylene glycol dimethyl ether, propylene glycol diethyl ether, and propylene glycol dibutyl ether; dipropylene glycol diethers, such as dipropylene glycol methyl-n-propyl ether, dipropylene glycol dimethyl ether, dipropylene glycol diethyl ether, and dipropylene glycol dibutyl ether; as well as higher analogues (i.e., tri- and tetra- analogues, e.g., triethylene glycol dimethyl ether, triethylene glycol butyl methyl ether, and tetraethylene glycol dimethyl ether) of the ethylene glycol and propylene glycol ethers mentioned herein.

Among the glycol-based solvents above, organic solvents with a chemical structure in which either one of R¹ and R² in formula (y) above is a hydrogen atom and the other one is an unsubstituted aliphatic acyl group are referred to as "glycol monoester solvents" in the present invention. Glycol monoester solvents correspond to aliphatic carboxylic acid monoesters of the glycol solvents described above.

Examples of glycol monoester solvents include, but are not limited to, ethylene glycol monoacetate, propylene glycol monoacetate, 1,4-butanediol monoacetate, 1,3-butylene glycol monoacetate and higher analogues (such as di- and tri- and tetra- analogues, e.g. triethylene glycol monoacetate) of glycol ethers.

Among the glycol-based solvents above, organic solvents with a chemical structure in which R¹ and R² in formula (y) above are both unsubstituted aliphatic acyl groups are referred to as "glycol diester solvents" in the present invention. Glycol diester solvents correspond to aliphatic carboxylic acid diesters of the glycol solvents described above.

Examples of glycol diester solvents include, but are not limited to, ethylene glycol diacetate, propylene glycol diacetate, 1,4-butanediol diacetate, 1,3-butylene glycol diacetate and higher analogues (such as di-, tri- and tetra- analogues, e.g. triethylene glycol diacetate) of glycol ethers.

Among the glycol-based solvents above, organic solvents with a chemical structure in which either one of R¹ and R² in formula (y) above is an unsubstituted alkyl group and the other one is an unsubstituted aliphatic acyl group are referred to as "glycol ester ether solvents" in the present invention. Glycol ester ether solvents correspond to aliphatic carboxylic acid monoesters of the glycol monoether solvents described above.

Examples of glycol ester ether solvents include, but are not limited to, ethylene glycol monoether acetates such as ethylene glycol monomethyl ether acetate, 2-ethoxyethyl acetate, and 2-butoxyethyl acetate; propylene glycol monoether acetates such as propylene glycol monomethyl ether acetate; and higher analogues (such as di-, tri-, and tetra- analogues, e.g., diethylene glycol monomethyl ether acetate and dipropylene glycol monomethyl ether acetate) of glycol ethers.

The glycol-based solvents discussed above are classified into "hydrophilic glycol-based solvents" and "hydrophobic glycol-based solvents" based on their chemical structures. In the present invention, "hydrophilic glycol-based solvents" refer to those glycol-based solvents that are glycol solvents, described above, while "hydrophobic glycol-based solvents" collectively refer to the glycol monoether solvents, glycol diether solvents, glycol monoester solvents, glycol diester solvents and glycol ester ether solvents discussed above.

Preferable examples of the solvent (c-1), which is a hydrophilic glycol-based solvent, include, but are not limited to, those glycol solvents that have low molecular weights / low boiling points, such as ethylene glycol, diethylene glycol, propylene glycol, and dipropylene glycol. In view of process compatibility and film formability, ethylene glycol is particularly preferable.

Preferable examples of the solvent (c-2), which is also a hydrophilic glycol-based solvent, include, but are not limited to, those glycol solvents that have higher molecular weights / higher boiling points than the solvent (c-1), such as triethylene glycol, tripropylene glycol, tetraethylene glycol, polyethylene glycol, and polypropylene glycol. In view of process compatibility and film formability, triethylene glycol is particularly preferable.

In an embodiment, the solvent (c-1) is ethylene glycol and the solvent (c-2) is triethylene glycol.

By contrast, the organic solvents used for the solvent (c-3) are not particularly limited as long as the relationship bp¹ < bp³ < bp² is satisfied. The solvent (c-3) may be a mixture comprising two or more organic solvents. In this case, each of these two or more organic solvents satisfies the relationship bp¹ < bp³ < bp².

In an embodiment, the solvent (c-3) is a hydrophobic glycol-based solvent, a nitrile, an alcohol, an aromatic ether, an aromatic ester or an aromatic hydrocarbon. In view of process compatibility and film formability, it is preferable to use, for the solvent (c-3), hydrophobic glycol-based solvents, discussed above, i.e. glycol monoether solvents, glycol diether solvents, glycol monoester solvents, glycol diester solvents and/or glycol ester ether solvents.

In an embodiment, the solvents (c-1) and (c-2) are both glycol solvents, and the solvent (c-3) is a glycol diether solvent.

In view of film formability, it is more preferable that the solvent (c-3) is a mixed solvent. The mixed solvent preferably comprises two or more glycol monoether solvents or glycol diether solvents, and particularly preferably comprises at least one glycol monoether for greater homogeneity of the solution. Among these, a combination of diethylene glycol butyl methyl ether and diethylene glycol monobutyl ether, or of diethylene glycol butyl methyl ether and diethylene glycol monoisobutyl ether is preferable, and most preferably, the mixed solvent comrpiese a combination of diethylene glycol butyl methyl ether and diethylene glycol monobutyl ether. In an embodiment, the solvent (c-3) is a mixture of two or more organic solvents comprising at least one glycol diether solvent.

The liquid carrier (c) may comprise a non-glycol-based solvent, i.e., an organic solvent other than the glycol-based solvents described above. Examples of non-glycol-based solvents include, but are not limited to, aromatic esters, aliphatic and aromatic ketones, organosulfur solvents (such as dimethyl sulfoxide (DMSO), 2,3,4,5-tetrahydrothiophene-1,1-dioxide (tetramethylene sulfone; sulfolane) and the like), tetrahydrofuran (THF), tetrahydropyran (THP), tetramethyl urea (TMU), *N,N*'-dimethylpropyleneurea, alkylated benzenes, such as xylene and isomers thereof, halogenated benzenes, *N*-methylpyrrolidinone (NMP), dimethylformamide (DMF), dimethylacetamide (DMAc), dichloromethane, acetonitrile, dioxanes, ethyl acetate, ethyl benzoate, methyl benzoate, dimethyl carbonate, ethylene carbonate, propylene carbonate, 3-methoxypropionitrile, 3-ethoxypropionitrile, diethyl fumarate, butyl benzoate, propylene carbonate or combinations thereof. Of these, diethyl fumarate, butyl benzoate, and propylene carbonate are preferable in view of film formability.

Aliphatic and aromatic ketones include, but are not limited to, acetone, acetonyl acetone, methyl ethyl ketone (MEK), methyl isobutyl ketone, methyl isobutenyl ketone, 2-hexanone, 2-pentanone, acetophenone, ethyl phenyl ketone, cyclohexanone, and cyclopentanone. In some embodiments, ketones with protons on the carbon located alpha to the ketone are avoided, such as cyclohexanone, methyl ethyl ketone, and acetone.

Other organic solvents are also considered that solubilize, completely or partially, the charge transporting material or that swell the charge transporting material. Such other solvents may be included in the liquid carrier in varying quantities to modify ink properties such as wetting, viscosity, morphology control.

Still other organic solvents suitable for use according to the present invention include ethers, for example, anisole, ethoxybenzene, and dimethoxybenzene.

Alcohols that may be used include aliphatic alcohols such as methanol, ethanol, trifluoroethanol, n-propanol, isopropanol, n-butanol, and t-butanol, and benzyl alcohol, and 2-(benzyloxy)ethanol. Aromatic ethers that may be used include methyl anisole, dimethyl anisole, ethyl anisole, butyl phenyl ether, butyl anisole, pentyl anisole, hexyl anisole, heptyl anisole, octyl anisole, phenoxy toluene. Aromatic hydrocarbons that may be used include pentylbenzene, hexylbenzene, heptylbenzene, octylbenzene, nonylbenzene, cyclohexylbenzene, and tetralin.

As disclosed herein, the organic solvents disclosed herein can be used in varying proportions in the liquid carrier, for example, to improve ink characteristics such as substrate wettability, ease of solvent removal, viscosity, surface tension, and jettability.

In some embodiments, the use of aprotic non-polar solvents can provide the additional benefit of increased life-times for devices with emitter technologies which are sensitive to protons, such as, for example, PHOLEDs.

In an embodiment, the liquid carrier comprises dimethyl sulfoxide, tetramethyl urea, or a mixture thereof.

As discussed above, in the process of liquid carrier volatilization, it is important that, after the majority of the solvent (c-1) has been volatilized, the liquid carrier have a composition mainly comprising solvent (c-2) and that also comprises a small amount of solvents (c-1) and (c-3), in order to form a flat film while suppressing the pile-up phenomenon. To achieve this, it is preferable that the ratios between the solvent (c-1), (c-2) and (c-3) are suitable. From this perspective, the ratio by weight ((c-1): (c-2)) of the solvent (c-1) to the solvent (c-2) is preferably 29:1 to 8:7, more preferably 9:1 to 3:7, and most preferably 5:1 to 23:7. The ratio of the weight of the solvent (c-1) to the total weight of the liquid carrier (c) is preferably 16% to 29%, more preferably 16% to 27%, even more preferably 20% to 25%, and most preferably 23% to 25%. The ratio of the weight of the solvent (c-2) to the total weight of the liquid carrier (c) is preferably 14% to 1%, more preferably 14% to 3%, even more preferably 10% to 5%, and most preferably 7% to 5%. It is most preferable that the ratios of the weights of the solvents (c-1), (c-2), and (c-3) to the total weight of the liquid carrier (c) are 23% to 25%, 7% to 5%, and 70%, respectively.

The amount of liquid carrier in the ink composition according to the present invention is from about 50 wt. % to about 99 wt. %, typically from about 75 wt. % to about 98 wt. %, still more typically from about 90 wt. % to about 95 wt. %, with respect to the total amount of ink composition.

As will be described below, the ink composition according to the present invention may be prepared by mixing each component such as the charge transporting material in the form of a solution or a dispersion in an organic solvent (a stock solution). The organic solvents added to the ink composition as a result of this operation are considered to be part of the liquid carrier.

The liquid carrier may be adapted for use and processing with other layers in a device such as the anode or light emitting layer.

In an embodiment, the ink composition of the present invention further comprises one or more amine compounds.

Amine compounds suitable for use in the ink compositions of the present invention include, but are not limited to, ethanolamines and alkylamines.

Examples of suitable ethanolamines include dimethylethanol amine [(CH₃)₂NCH₂CH₂OH], triethanolamine [N(CH₂CH₂OH)₃], and *N-tert-*butyldiethanolamine [t-C₄H₉N(CH₂CH₂OH)₂].

Alkylamines include primary, secondary, and tertiary alkylamines. Examples of primary alkylamines include, for example, ethylamine [C₂H₅NH₂], n-butylamine [C₄H₉NH₂], t-butylamine [C₄H₉NH₂], n-hexylamine [C₆H₁₃NH₂], 2-ethylhexylamine [C₈H₁₇NH₂], n-decylamine [C₁₀H₂₁NH₂], and ethylenediamine [H₂NCH₂CH₂NH_{2]}. Secondary alkylamines include, for example, diethylamine [(C₂H₅)₂NH], di(n-propylamine) [(n-C₃H₉)₂NH], di(isopropylamine)[(i-C₃H₉)₂NH], and dimethyl ethylenediamine [CH₃NHCH₂CH₂NHCH₃]. Tertiary alkylamines include, for example, trimethylamine [(CH₃)₃N], triethylamine [(C₂H₅)₃N], tri(n-butyl)amine [(C₄H₉)₃N], and tetramethyl ethylenediamine [(CH₃)₂NCH₂CH₂N(CH₃)₂].

In some embodiments, the amine compound is a tertiary alkylamine. In an embodiment, the amine compound is triethylamine.

In some embodiments, the amine compound is a mixture of a tertiary alkylamine compound and an amine compound other than a tertiary alkylamine compound. In an embodiment, the amine compound other than a tertiary alkylamine compound is a primary alkylamine compound. In an embodiment, the primary alkylamine compound is at least one selected from the group consisting of ethylamine, n-butylamine, t-butylamine, n-hexylamine, 2-ethylhexylamine, n-decylamine, and ethylenediamine, and, among these, 2-ethylhexylamine or n-butylamine is preferable.

The amount of the amine compound can be adjusted and measured as a weight percentage relative to the total amount of the ink composition. In an embodiment, the amount of the amine compound is at least 0.01 wt. %, at least 0.10 wt. %, at least 1.00 wt. %, at least 1.50 wt. %, or at least 2.00 wt. %, with respect to the total amount of the ink composition. In an embodiment, the amount of the amine compound is from about 0.01 wt. % to about 2.00 wt. %, typically from about 0.05 wt. % to about 1.50 wt. %, more typically from about 0.1 wt. % to about 1.0 wt. %, with respect to the total amount of the ink composition. At least a portion of the amine compound may be present in the form of an ammonium salt, e.g., a trialkylammonium salt, of the sulfonated conjugated polymer (an amine adduct of the sulfonated polythiophene).

This amine compound is added typically at the time of preparing the final ink composition, but may be added in advance at an earlier point in time. For example, as described above, the amine compound may be added to the sulfonated conjugated polymer, thereby converting it to the corresponding ammonium salt, e.g., a trialkylammonium salt (an amine adduct of the sulfonated polythiophene), followed by reduction treatment. Alternatively, the amine compound (e.g., triethylamine) may be added to a solution of a sulfonated conjugated polymer that has undergone reduction treatment, and the sulfonated conjugated polymer may be precipitated as an ammonium salt (e.g., a triethylammonium salt) in powder form, which can be recovered.

Although there is no particular limitation on methods of such treatment, exemplary methods include the following: the sulfonated polythiophene that has been subjected to reduction treatment is dissolved by adding to it water and triethylamine, the mixture is stirred under heating (for example, at 60 °C), and then isopropyl alcohol and acetone are added to the obtained solution to cause precipitation of the triethylammonium salt of the sulfonated conjugated polymer, which is filtered and recovered.

The ink composition of the present invention may optionally further comprise one or more matrix compounds known to be useful in hole injection layers (HILs) or hole transport layers (HTLs).

The optional matrix compound can be a lower or higher molecular weight compound, and is different from the polythiophene described herein. The matrix compound can be, for example, a synthetic polymer that is different from the polythiophene. See, for example, US Patent Publication No. 2006/0175582 published Aug. 10, 2006. The synthetic polymer can comprise, for example, a carbon backbone. In some embodiments, the synthetic polymer has at least one polymer side group comprising an oxygen atom or a nitrogen atom. The synthetic polymer may be a Lewis base. Typically, the synthetic polymer comprises a carbon backbone and has a glass transition temperature of greater than 25 °C. The synthetic polymer may also be a semi-crystalline or crystalline polymer that has a glass transition temperature equal to or lower than 25 °C and/or a melting point greater than 25 °C. The synthetic polymer may comprise one or more acidic groups, for example, sulfonic acid groups.

In an embodiment, the ink composition of the present invention further comprises a synthetic polymer comprising one or more acidic groups.

In an embodiment, the synthetic polymer is a polymeric acid comprising one or more repeating units comprising at least one alkyl or alkoxy group which is substituted by at least one fluorine atom and at least one sulfonic acid (-SO₃H) moiety, wherein said alkyl or alkoxy group is optionally interrupted by at least one ether linkage (-O-) group.

In an embodiment, the polymeric acid comprises a repeating unit complying with formula (II) and a repeating unit complying with formula (III) 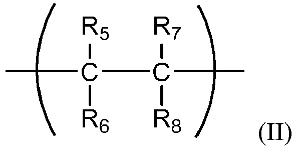 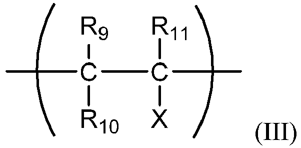 wherein each occurrence of R₅, R₆, R₇, R₈, R₉, R₁₀, and R₁₁ is, independently, H, halogen, fluoroalkyl, or perfluoroalkyl; and X is -[OC(RₕRᵢ)-C(RⱼRₖ)]_{q}-O-[CR₁Rₘ]_{z}-SO₃H, wherein each occurrence of Rₕ, Rᵢ, Rⱼ, Rₖ, Rₗ and Rₘ is, independently, H, halogen, fluoroalkyl, or perfluoroalkyl; q is 0 to 10; and z is 1 to 5.

In an embodiment, each occurrence of R₅, R₆, R₇, and R₈ is, independently, Cl or F. In an embodiment, each occurrence of R₅, R₇, and R₈ is F, and R₆ is Cl. In an embodiment, each occurrence of R₅, R₆, R₇, and R₈ is F.

In an embodiment, each occurrence of R₉, R₁₀, and R₁₁ is F.

In an embodiment, each occurrence of Rₕ, Rᵢ, Rⱼ, Rₖ, Rₗ and Rₘ is, independently, F, (C₁-C₈) fluoroalkyl, or (C₁-C₈) perfluoroalkyl.

In an embodiment, each occurrence of Rₗ and Rₘ is F; q is 0; and z is 2.

In an embodiment, each occurrence of R₅, R₇, and R₈ is F, and R₆ is Cl; and each occurrence of Rₗ and Rₘ is F; q is 0; and z is 2.

In an embodiment, each occurrence of R₅, R₆, R₇, and R₈ is F; each occurrence of Rₗ and Rₘ is F; q is 0; and z is 2.

The ratio of the number of repeating units complying with formula (II) ("n") to the number of the repeating units complying with formula (III) ("m") is not particularly limited. The n:m ratio is typically from 9:1 to 1:9, more typically 8:2 to 2:8. In an embodiment, the n:m ratio is 9:1. In an embodiment, the n:m ratio is 8:2.

The polymeric acid suitable for use according to the present invention may be synthesized using methods known to those of ordinary skill in the art or obtained from commercially available sources. For instance, the polymers comprising a repeating unit complying with formula (II) and a repeating unit complying with formula (III) may be made by co-polymerizing monomers represented by formula (IIa) with monomers represented by formula (IIIa) 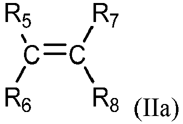 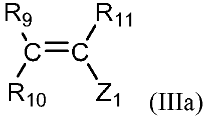 wherein Zₗ is -[OC(RₕRᵢ)-C(RⱼRₖ)]_{q}-O-[CR₁Rₘ]_{z}-SO₂F, wherein Rₕ, Rᵢ, Rⱼ, Rₖ, Rₗ and Rₘ, q, and z are as defined herein, according to known polymerization methods, followed by conversion to sulfonic acid groups by hydrolysis of the sulfonyl fluoride groups.

For example, tetrafluoroethylene (TFE) or chlorotrifluoroethylene (CTFE) may be copolymerized with one or more fluorinated monomers comprising a precursor group for sulfonic acid, such as, for example, F₂C=CF-O-CF₂-CF₂-SO₂F; F₂C=CF-[O-CF₂-CR₁₂F-O]_{q}-CF₂-CF₂-SO₂F, wherein R₁₂ is F or CF₃ and q is 1 to 10; F₂C=CF-O-CF₂-CF₂-CF₂-SO₂F; and F₂C=CF-OCF₂-CF₂-CF₂-CF₂-SO₂F.

The equivalent weight of the polymeric acid is defined as the mass, in grams, of the polymeric acid per mole of acidic groups present in the polymeric acid. The equivalent weight of the polymeric acid is from about 400 to about 15,000 g polymer/mol acid, typically from about 500 to about 10,000 g polymer/mol acid, more typically from about 500 to 8,000 g polymer/mol acid, even more typically from about 500 to 2,000 g polymer/mol acid, still more typically from about 600 to about 1,700 g polymer/mol acid.

Such polymeric acids are, for instance, those marketed by E. I. DuPont under the trade name NAFION®, those marketed by Solvay Specialty Polymers under the trade name AQUIVION®, or those marketed by Asahi Glass Co. under the trade name FLEMION®.

In an embodiment, the synthetic polymer is a polyether sulfone comprising one or more repeating units comprising at least one sulfonic acid (-SO₃H) moiety.

In an embodiment, the polyether sulfone comprises a repeating unit complying with formula (IV) 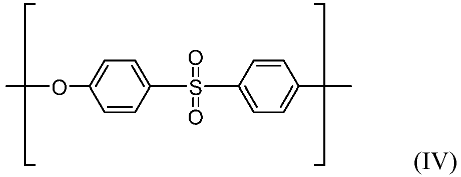 and a repeating unit selected from the group consisting of a repeating unit complying with formula (V) and a repeating unit complying with formula (VI) 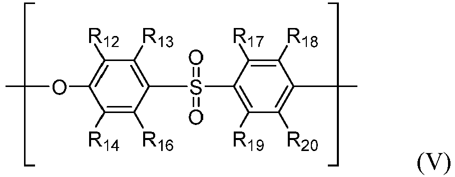 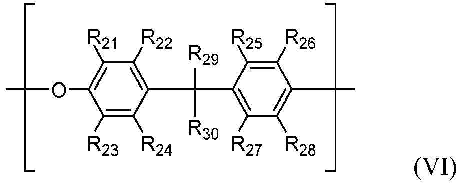 wherein R₁₂-R₂₀ are each, independently, H, halogen, alkyl, or SO₃H, provided that at least one of R₁₂-R₂₀ is SO₃H; and wherein R₂₁-R₂₈ are each, independently, H, halogen, alkyl, or SO₃H, provided that at least one of R₂₁-R₂₈ is SO₃H, and R₂₉ and R₃₀ are each H or alkyl.

In an embodiment, R₂₉ and R₃₀ are each alkyl. In an embodiment, R₂₉ and R₃₀ are each methyl.

In an embodiment, R₁₂-R₁₇, R₁₉, and R₂₀, are each H and R₁₈ is SO₃H.

In an embodiment, R₂₁-R₂₅, R₂₇, and R₂₈, are each H and R₂₆ is SO₃H.

In an embodiment, the polyether sulfone is represented by formula (VII) 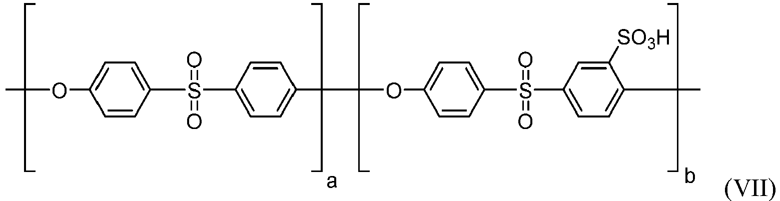 wherein a is from 0.7 to 0.9 and b is from 0.1 to 0.3.

The polyether sulfone may further comprise other repeating units, which may or may not be sulfonated.

For example, the polyether sulfone may comprise a repeating unit of formula (VIII) 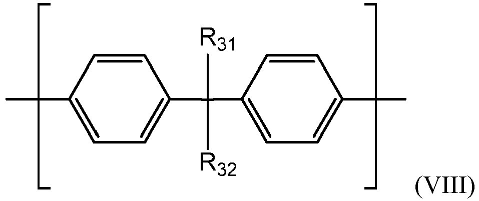 wherein R₃₁ and R₃₂ are each, independently, H or alkyl.

Any two or more repeating units described herein may together form a repeating unit and the polyether sulfone may comprise such a repeating unit. For example, the repeating unit complying with formula (IV) may be combined with a repeating unit complying with formula (VI) to give a repeating unit complying with formula (IX)

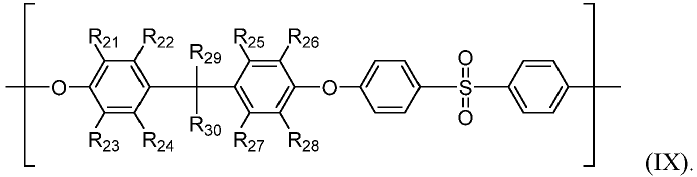

Analogously, for example, the repeating unit complying with formula (IV) may be combined with a repeating unit complying with formula (VIII) to give a repeating unit complying with formula (X)

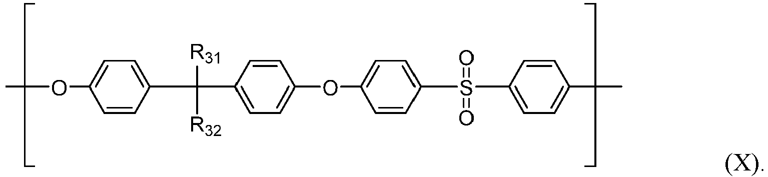

In an embodiment, the polyether sulfone is represented by formula (XI) 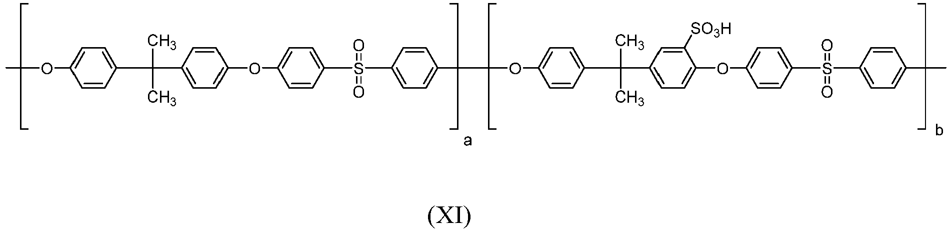 wherein a is from 0.7 to 0.9 and b is from 0.1 to 0.3.

Polyether sulfones comprising one or more repeating units comprising at least one sulfonic acid (-SO₃H) moiety are commercially available, for example, sulfonated polyether sulfones marketed as S-PES by Konishi Chemical Ind. Co., Ltd.

The optional matrix compound can be a planarizing agent. A matrix compound or a planarizing agent may be comprised of, for example, a polymer or oligomer such as an organic polymer, such as poly(styrene) or poly(styrene) derivatives; poly(vinyl acetate) or derivatives thereof; poly(ethylene glycol) or derivatives thereof; poly(ethylene-co-vinyl acetate); poly(pyrrolidone) or derivatives thereof (e.g., poly(1-vinylpyrrolidone-co-vinyl acetate)); poly(vinyl pyridine) or derivatives thereof; poly(methyl methacrylate) or derivatives thereof; poly(butyl acrylate); poly(aryl ether ketones); poly(aryl sulfones); poly(esters) or derivatives thereof; or combinations thereof.

In an embodiment, the matrix compound is poly(styrene) or a poly(styrene) derivative.

In an embodiment, the matrix compound is poly(4-hydroxystyrene).

The optional matrix compound or planarizing agent may be comprised of, for example, at least one semiconducting matrix component. The semiconducting matrix component is different from the polythiophene described herein. The semiconducting matrix component can be a semiconducting small molecule or a semiconducting polymer that is typically comprised of repeat units comprising hole carrying units in the main-chain and/or in a side-chain. The semiconducting matrix component may be in the neutral form or may be doped, and is typically soluble and/or dispersible in organic solvents, such as toluene, chloroform, acetonitrile, cyclohexanone, anisole, chlorobenzene, o-dichlorobenzene, ethyl benzoate and mixtures thereof.

The amount of the optional matrix compound can be controlled and measured as a weight percentage relative to the amount of the doped or undoped polythiophene. In an embodiment, the amount of the optional matrix compound is from 0 to 99.5 wt. %, typically from about 10 wt. % to about 98 wt. %, more typically from about 20 wt. % to about 95 wt. %, still more typically about 25 wt. % to about 45 wt. %, relative to the amount of the doped or undoped polythiophene. In the embodiment with 0 wt. %, the ink composition is free of matrix compound.

In an embodiment, the polythiophene comprising a repeating unit complying with formula (I) is doped with a dopant. Dopants are known in the art. See, for example, U.S. Patent 7,070,867; US Publication 2005/0123793; and US Publication 2004/0113127. The dopant can be an ionic compound. The dopant can comprise a cation and an anion. One or more dopants may be used to dope the polythiophene comprising a repeating unit complying with formula (I).

The cation of the ionic compound can be, for example, V, Cr, Mn, Fe, Co, Ni, Cu, Nb, Mo, Tc, Ru, Rh, Pd, Ag, Ta, W, Re, Os, Ir, Pt, or Au.

The cation of the ionic compound can be, for example, gold, molybdenum, rhenium, iron, and silver cation.

In some embodiments, the dopant can comprise a sulfonate or a carboxylate, including alkyl, aryl, and heteroaryl sulfonates and carboxylates. As used herein, "sulfonate" refers to a -SO₃M group, wherein M may be H⁺ or an alkali metal ion, such as, for example, Na⁺, Li⁺, K⁺, Rb⁺, Cs⁺; or ammonium (NH₄⁺). As used herein, "carboxylate" refers to a -CO₂M group, wherein M may be H⁺ or an alkali metal ion, such as, for example, Na⁺, Li⁺, K⁺, Rb⁺, Cs⁺; or ammonium (NH₄⁺). Examples of sulfonate and carboxylate dopants include, but are not limited to, benzoate compounds, heptafluorobutyrate, methanesulfonate, trifluoromethanesulfonate, p-toluenesulfonate, pentafluoropropionate, and polymeric sulfonates, perfluorosulfonate-containing ionomers, and the like.

In some embodiments, the dopant does not comprise a sulfonate or a carboxylate.

In some embodiments, dopants may comprise sulfonylimides, such as, for example, bis(trifluoromethanesulfonyl)imide; antimonates, such as, for example, hexafluoroantimonate; arsenates, such as, for example, hexafluoroarsenate; phosphorus compounds, such as, for example, hexafluorophosphate; and borates, such as, for example, tetrafluoroborate, tetraarylborates, and trifluoroborates. Examples of tetraarylborates include, but are not limited to, halogenatedtetraarylborates, such as tetrakispentafluorophenylborate (TPFB). Examples of trifluoroborates include, but are not limited to, (2-nitrophenyl)trifluoroborate, benzofurazan-5-trifluoroborate, pyrimidine-5-trifluoroborate, pyridine-3-trifluoroborate, and 2,5-dimethylthiophene-3-trifluoroborate.

A dopant can be, for example, a material that will undergo one or more electron transfer reaction(s) with, for example, a conjugated polymer, thereby yielding a doped polythiophene. The dopant can be selected to provide a suitable charge balancing counter-anion. A reaction can occur upon mixing of the polythiophene and the dopant as known in the art. For example, the dopant may undergo spontaneous electron transfer from the polymer to a cation-anion dopant, such as a metal salt, leaving behind a conjugated polymer in its oxidized form with an associated anion and free metal. See, for example, Lebedev et al., Chem. Mater., 1998, 10, 156-163. As disclosed herein, the polythiophene and the dopant can refer to components that will react to form a doped polymer. The doping reaction can be a charge transfer reaction, wherein charge carriers are generated, and the reaction can be reversible or irreversible. In some embodiments, silver ions may undergo electron transfer to or from silver metal and the doped polymer.

In the final formulation, the composition can be distinctly different from the combination of original components (i.e., polythiophene and/or dopant may or may not be present in the final composition in the same form as before mixing).

For the dopant, an inorganic acid, an organic acid, an organic or inorganic oxidizing agent, or the like is used.

For the organic acid, a polymeric organic acid and/or a low molecular organic acid (non-polymeric organic acid) are used.

In an embodiment, the organic acid is a sulfonic acid, and may also be a salt thereof (-SO₃M, wherein M is an alkali-metal ion (e.g., Na⁺, Li⁺, K⁺, Rb⁺, Cs⁺, etc.), ammonium (NH₄⁺), a mono-, di-, and tri- alkylammonium (e.g., triethylammonium)). Among the sulfonic acids, an arylsulfonic acid is preferred.

In some embodiments, examples of dopants include, but are not limited to, inorganic strong acids such as hydrogen chloride, sulfuric acid, nitric acid, and phosphoric acid; Lewis acids such as aluminum (III) chloride (AlCl₃), titanium (IV) tetrachloride (TiCl₄), boron tribromide (BBr₃), boron trifluoride ether complex (BF₃·OEt₂), iron (III) chloride (FeCl₃), copper (II) chloride (CuCl₂), antimony (V) pentachloride (SbCl₅), arsenic (V) pentafluoride (AsFs), phosphorus pentafluoride (PF₅), and tris(4-bromophenyl)aluminum hexachloroantimonate (TBPAH); polymeric organic acids such as polystyrene sulfonic acid; low molecular weight organic acids (non-polymeric organic acids) such as benzenesulfonic acid, tosylic acid, camphorsulfonic acid, hydroxybenzenesulfonic acid, 5-sulfosalicylic acid, dodecylbenzenesulfonic acid, 1,4-benzodioxanedisulfonic acid derivatives described in WO 2005/000832, arylsulfonic acid derivatives described in WO 2006/025342, dinonylnaphthalenesulfonic acid derivatives described in JP-A-2005-108828; organic or inorganic oxidizing agents such as 7,7,8,8-tetracyanoquinodimethane (TCNQ), 2,3-dichloro-5,6-dicyano-1,4-benzoquinone (DDQ), iodine, heteropoly acid compounds, and the like.

In one preferred embodiment, polystyrene sulfonic acid (PSS) is not included in the scope of the aryl sulfonic acid contained in the composition of the present invention from the perspective of reproducibly obtaining a charge transporting film that has excellent flatness and provides excellent lifetime characteristics when applied in an OLED.

In some embodiments, the dopant comprises at least one selected from the group consisting of an arylsulfonic acid compound, a heteropoly acid compound, an ionic compound comprising an element belonging to Group 13 or 15 of the long periodic table.

Particularly preferred dopants include polymeric organic acids such as polystyrene sulfonic acid, and low molecular organic acids such as 5-sulfosalicylic acid, dodecylbenzenesulfonic acid, 1,4-benzodioxanedisulfonic acid derivatives described in WO 2005/000832, and dinonylnaphthalenesulfonic acid derivatives described in JP 2005-108828. A sulfonic acid derivative represented by the following formula (2) can also be suitably used. 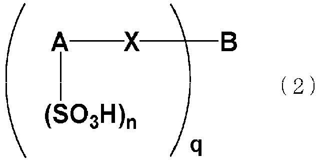 wherein X represents O, S or NH; A represents a naphthalene or anthracene ring which may have a substituent other than X or the n number of (SO₃H) groups; and B represents an unsubstituted or substituted hydrocarbon group, a 1,3,5-triazine group, or an unsubstituted or substituted group represented by formula (3) or (4) below: 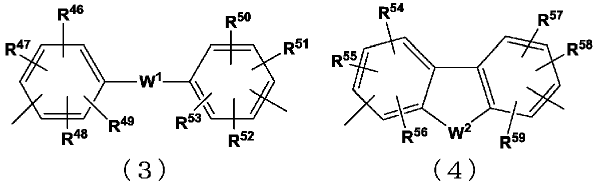
wherein W¹ and W² each, independently, represent O, S, an S(O) group, an S(O₂) group, or an unsubstituted or substituted N, Si, P, or P(O) group; W¹ may also be a single bond; R⁴⁶ to R⁵⁹ each, independently, represent a hydrogen atom or a halogen atom;
n represents the number of sulfonic acid groups attached to A and is an integer satisfying 1 ≤ n ≤ 4; and q represents the number of bonds between B and X, and is an integer satisfying 1 ≤ q.

R⁴⁶ to R⁵⁹ in formula (3) or (4) are preferably fluorine atoms, and more preferably all fluorine atoms. W¹ in formula (3) is preferably a single bond. Most preferably, W¹ in formula (3) is a single bond, and R⁴⁶ to R⁵³ are all fluorine atoms.

For the arylsulfonic acid compound according to the present invention, a compound represented by the following formula (6) may further be used: 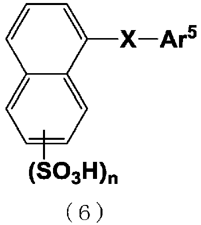 wherein X represents O, S or NH; Ar⁵ represents an aryl group; and n represents the number of sulfonic groups and is an integer of 1 to 4.

In formula (6) above, X represents O, S or NH, and particularly preferably is O for ease of synthesis.

n represents the number of sulfonic groups attached to the naphthalene ring and is an integer of 1 to 4, and preferably, n=1 or 2, for the purpose of imparting high electron acceptability and high solubility to the compound. Among them, the compound represented by the following formula (7) is suitable: 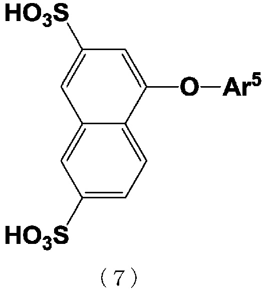 wherein Ar⁵ represents an aryl group.

Examples of aryl groups in formulae (6) and (7) include aryl groups such as a phenyl group, a xylyl group, a tolyl group, a biphenyl group, and a naphthyl group, and these aryl groups may have a substituent.

Examples of such substituents include, but are not limited to, a hydroxyl group, an amino group, a silanol group, a thiol group, a carboxyl group, a phosphoric acid group, a phosphate ester group, an ester group, a thioester group, an amide group, a nitro group, a cyano group, a monovalent hydrocarbon group, an organooxy group, an organoamino group, an organosilyl group, an organothio group, an acyl group, a sulfonic group, a halogen atom, and the like.

Among these aryl groups, an aryl group represented by the following formula (8), in particular, is suitably used: 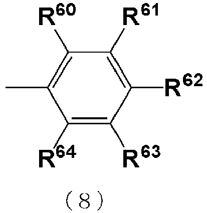 wherein R⁶⁰ to R⁶⁴ each, independently, represent a hydrogen atom, a halogen atom, a nitro group, an alkyl group having 1 to 10 carbon atoms, a halogenated alkyl group having 1 to 10 carbon atoms, and a halogenated alkenyl group having 2 to 10 carbon atoms.

In formula (8), the halogen atom may be any of chlorine, bromine, fluorine, and iodine atoms, but in the present invention, a fluorine atom is particularly suitable.

Examples of alkyl groups having 1 to 10 carbon atoms include methyl, ethyl, n-propyl, i-propyl, n-butyl, i-butyl, t-butyl, n-pentyl, n-hexyl, n-heptyl, n-octyl, n-nonyl, 2-ethylhexyl, n-decyl, cyclopentyl, cyclohexyl, and the like.

Examples of halogenated alkyl groups having 1 to 10 carbon atoms include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl, 1,1,2,2,3,3,4,4,4-nonafluorobutyl, and the like.

Examples of halogenated alkenyl groups having 2 to 10 carbon atoms include a perfluorovinyl group, a perfluoropropenyl group (allyl group), a perfluorobutenyl group, and the like.

Among these, for the purpose of further enhancing solubility in organic solvents, it is particularly preferable to use an aryl group represented by the following formula (9): 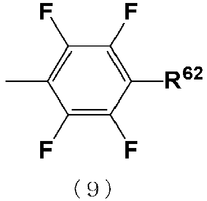 wherein, R⁶² represents a hydrogen atom, a halogen atom, a nitro group, an alkyl group having 1 to 10 carbon atoms, a halogenated alkyl group having 1 to 10 carbon atoms, or a halogenated alkenyl group having 2 to 10 carbon atoms.

In formula (9), R⁶², in particular, is preferably a halogenated alkyl group, a halogenated alkynyl group, or a nitro group, and more preferably a trifluoromethyl group, a perfluoropropenyl group, or a nitro group.

Further, an ionic compound consisting of an anion represented by formula (5a) or Z¹ below and a countercation thereof can also be suitably used as a dopant. 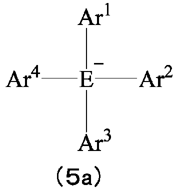 wherein E represents an element belonging to Group 13 or 15 of the long periodic table; and Ar¹ to Ar⁴ each, independently, represent an aromatic hydrocarbon group which may have a substituent or an aromatic heterocyclic group which may have a substituent.

In formula (5a), E is preferably boron, gallium, phosphorus, or antimony among the elements belonging to Group 13 or Group 15 of the long period periodic table, and more preferably boron.

Examples of aromatic hydrocarbon groups and aromatic heterocyclic groups in formula (5a) include a monovalent group derived from a 5- or 6-membered single-ring or bicyclo- to tetracyclo- fused-ring system. Among these, a monovalent group derived from a benzene ring, a naphthalene ring, a pyridine ring, a pyrazine ring, a pyridazine ring, a pyrimidine ring, a triazine ring, a quinoline ring, or an isoquinoline ring is preferable from the perspective of stability and heat resistance of the compound.

Further, it is more preferable that at least one group among Ar¹ to Ar⁴ has one or more fluorine atoms or chlorine atoms as substituents. In particular, it is most preferable that Ar¹ to Ar⁴ are perfluoroaryl groups in which all the hydrogen atoms are substituted with fluorine atoms. Specific examples of perfluoroaryl groups include a pentafluorophenyl group, a heptafluoro-2-naphthyl group, a tetrafluoro-4-pyridyl group, and the like.

Examples of Z¹ include an ion represented by the following formula (5b), and a hydroxide ion, fluoride ion, chloride ion, bromide ion, iodide ion, cyanide ion, nitrate ion, nitrite ion, sulfate ion, sulfite ion, perchlorate ion, perbromate ion, periodate ion, chlorate ion, chlorite ion, hypochlorite ion, phosphate ion, phosphite ion, hypophosphite ion, borate ion, isocyanate ion, hydrosulfide ion, tetrafluoroborate ion, hexafluorophosphate ion, and hexachloroantimonate ion; carboxylate ions such as an acetate ion, trifluoroacetate ion, and benzoate ion; sulfonate ions such as methanesulfonate and trifluoromethanesulfonate ions; and alkoxy ions, such as a methoxy ion, t-butoxy ion, and the like.

E²X₆⁻ (5b)

wherein E² represents an element belonging to Group 15 of the long periodic table; and X represents a halogen atom such as a fluorine atom, a chlorine atom, or a bromine atom.

In formula (5b), E² is preferably a phosphorus atom, an arsenic atom, or an antimony atom, and is preferably a phosphorus atom from the perspectives of the stabilization, ease of synthesis and purification, and toxicity of the compound.

X is preferably a fluorine atom or a chlorine atom, most preferably a fluorine atom, from the perspectives of stability and ease of synthesis and purification of the compound.

Among the foregoing, an ionic compound which is the combination of an anion and a cation represented by the following formulae (10), (11), (12), or (13) (see Japanese Patent No. 5381931 (Patent Document 5)) can be suitably used.

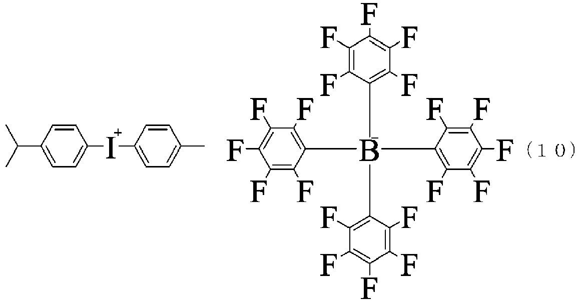

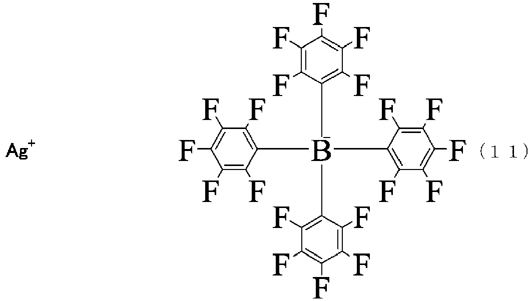

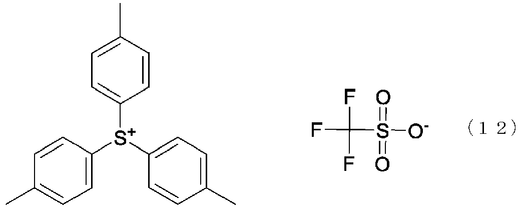

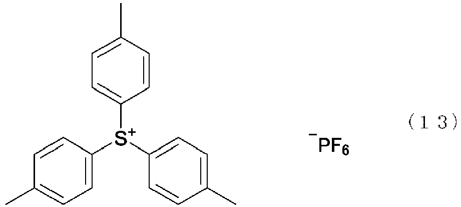

Heteropoly acid compounds are also particularly preferable as dopants. A heteropoly acid compound is a polyacid having a structure in which a heteroatom is located at the center of the molecule, typically represented by a Keggin-type chemical structure shown in formula (A) or a Dawson-type chemical structure shown in formula (B), and is formed by condensation of an isopolyacid, which is an oxoacid of vanadium (V), molybdenum (Mo), tungsten (W), or the like with an oxoacid of a different element. Primary examples of such oxoacids of heterogeneous elements include oxoacids of silicon (Si), phosphorus (P), and arsenic (As).

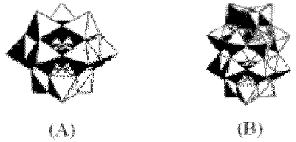

Specific examples of heteropoly acid compounds include phosphomolybdic acid, silicomolybdic acid, phosphotungstic acid, phosphotungstomolybdic acid, silicotungstic acid, and the like. In consideration of the characteristics of an organic EL device comprising the resulting film, phosphomolybdic acid, phosphotungstic acid and silicotungstic acid are preferable, and phosphotungstic acid is more preferable.

These heteropoly acid compounds may be synthesized by a known synthesis method and used, but are also commercially available. For example, phosphotungstic acid (phosphotungstic acid hydrate or 12-tungstophosphoric acid n-hydrate, chemical formula: H₃(PW₁₂O₄₀)·nH₂O), and phosphomolybdic acid (phosphomolybdic acid hydrate or 12-molybdo (VI) phosphoric acid n-hydrate, chemical formula: H₃(PMo₁₂O₄₀)·nH₂O (n≈30)) are available from manufacturers such as Kanto Chemical Co., Inc., Wako Pure Chemical Industries, Ltd., Sigma-Aldrich Japan, Nippon Inorganic Colour & Chemical Co., Ltd., and Japan New Metals Co., Ltd.

In an embodiment, the sulfonic acid ester compound represented by formula (1) below, which is a precursor to a dopant, may be used as a dopant.

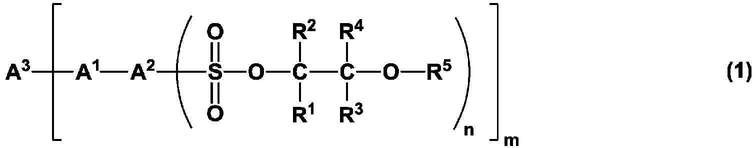

In formula (1), R¹ to R⁴ are each, independently, a hydrogen atom or a linear or branched alkyl group of 1 to 6 carbon atoms; and R⁵ is an optionally substituted monovalent hydrocarbon group of 2 to 20 carbon atoms.

Examples of linear or branched alkyl groups include, but are not limited to, a methyl group, an ethyl group, an n-propyl group, an isopropyl group, an n-butyl group, an isobutyl group, a tert-butyl group, and an n-hexyl group. Of these, an alkyl group of 1 to 3 carbon atoms is preferable.

Examples of monovalent hydrocarbon groups of 2 to 20 carbon atoms include alkyl groups such as an ethyl group, an n-propyl group, an isopropyl group, ab n-butyl group, an isobutyl group and a tert-butyl group, aryl groups such as a phenyl group, a naphthyl group and a phenanthryl group, and the like.

It is preferable for R¹ or R³ to be a linear alkyl group of 1 to 3 carbon atoms and for the remainder of R¹ to R⁴ to be hydrogen atoms. In addition, it is preferable for R¹ to be a linear alkyl group of 1 to 3 carbon atoms, and for R² to R⁴ to be hydrogen atoms. The linear alkyl group of 1 to 3 carbon atoms is preferably a methyl group. R⁵ is preferably a linear alkyl group of 2 to 4 carbon atoms or a phenyl group.

In formula (1), A¹ represents -O- or -S-, and is preferably -O-. A² is a group having a valence of n + 1 that is derived from naphthalene or anthracene, and is preferably a group derived from naphthalene. A³ is an m-valent group derived from perfluorobiphenyl.

In formula (1), m is an integer that satisfies 2 ≤ m ≤ 4, and is preferably 2. Also, n is an integer that satisfies 1 ≤ n ≤4 , and is preferably 2.

Some embodiments allow for removal of reaction by-products from the doping process. For example, the metals, such as silver, can be removed by filtration.

Materials can be purified to remove, for example, halogens and metals. Halogens include, for example, chloride, bromide and iodide. Metals include, for example, the cation of the dopant, including the reduced form of the cation of the dopant, or metals left from catalyst or initiator residues. Metals include, for example, silver, nickel, and magnesium. The amounts can be less than, for example, 100 ppm, or less than 10 ppm, or less than 1 ppm.

Metal content, including silver content, can be measured by ICP-MS, particularly for concentrations greater than 50 ppm.

In an embodiment, when the polythiophene is doped with a dopant, the polythiophene and the dopant are mixed to form a doped polymer composition. Mixing may be achieved using any method known to those of ordinary skill in the art. For example, a solution comprising the polythiophene may be mixed with a separate solution comprising the dopant. The solvent or solvents used to dissolve the polythiophene and the dopant may be one or more solvents described herein. A reaction can occur upon mixing of the polythiophene and the dopant as known in the art. The resulting doped polythiophene composition comprises between about 40% and 75% by weight of the polymer and between about 25% and 55% by weight of the dopant, based on the composition. In another embodiment, the doped polythiophene composition comprises between about 50% and 65% by weight of the polythiophene and between about 35% and 50% by weight of the dopant, based on the composition. Typically, the amount by weight of the polythiophene is greater than the amount by weight of the dopant. Typically, the dopant can be a silver salt, such as silver tetrakis(pentafluorophenyl)borate in an amount of about 0.25 to 0.5 m/ru, wherein m is the molar amount of silver salt and ru is the molar amount of polymer repeat unit.

The total solids content (% TS) in the ink composition according to the present invention is from about 0.1 wt. % to about 50 wt. %, typically from about 0.3 wt. % to about 40 wt. %, more typically from about 0.5 wt. % to about 15 wt. %, still more typically from about 1 wt. % to about 5 wt. %, with respect to the total amount of the ink composition.

The ink compositions described herein may be prepared according to any suitable method known to the ordinarily-skilled artisan. For example, in one method, an initial aqueous mixture is prepared by mixing an aqueous dispersion of the polythiophene described herein with an aqueous dispersion of polymeric acid, if desired, another matrix compound, if desired, and additional solvent, if desired. The solvents, including water, in the mixture are then removed, typically by evaporation. The resulting dry product is then dissolved or dispersed in one or more organic solvents, such as dimethyl sulfoxide, and filtered under pressure to yield a mixture. An amine compound may optionally be added to such mixture. The mixture is then mixed with a dispersion of the metal oxide nanoparticles to yield the final ink composition.

In another method, the ink compositions described herein may be prepared from stock solutions. For example, a stock solution of the polythiophene described herein can be prepared by isolating the polythiophene in dry form from an aqueous dispersion, typically by evaporation. The dried polythiophene is then combined with one or more organic solvents and, optionally, an amine compound. If desired, a stock solution of the polymeric acid described herein can be prepared by isolating the polymeric acid in dry form from an aqueous dispersion, typically by evaporation. The dried polymeric acid is then combined with one or more organic solvents. Stock solutions of other optional matrix materials can be made analogously. Stock solutions of the metal oxide nanoparticles can be made, for example, by diluting commercially-available dispersions with one or more organic solvents, which may be the same or different from the solvent or solvents contained in the commercial dispersion. Desired amounts of the respective stock solutions are then combined to form the ink compositions of the present invention.

Still in another method, the ink compositions described herein may be prepared by isolating the individual components in dry form as described herein, but instead of preparing stock solutions, the components in dry form are combined and then dissolved in one or more organic solvents to provide the ink composition.

The ink composition according to the present invention can be cast and annealed as a film on a substrate.

Thus, the present invention also relates to a process for forming a hole-carrying film, the process comprising:
1) coating a substrate with an ink composition disclosed herein; and
2) annealing the coating on the substrate, thereby forming the hole-carrying film.

The application of a coating of the ink composition on a substrate can be carried out by methods known in the art including, for example, spin casting, spin coating, dip casting, dip coating, slot-dye coating, inkjet printing, gravure coating, doctor blading, and any other methods known in the art for fabrication of, for example, organic electronic devices. It is preferable to coat a substrate with the ink composition by inkjet printing.

The substrate can be flexible or rigid, organic or inorganic. Suitable substrate compounds include, for example, glass, including, for example, display glass, ceramic, metal, and plastic films.

As used herein, the term "annealing" refers to any general process for forming a hardened layer, typically a film, on a substrate coated with the ink composition of the present invention. General annealing processes are known to those of ordinary skill in the art. Typically, the solvent is removed from the substrate coated with the ink composition. The removal of the solvent may be achieved, for example, by subjecting the coated substrate to pressure less than atmospheric pressure, and/or by heating the coating layered on the substrate to a certain temperature (annealing temperature), maintaining the temperature for a certain period of time (annealing time), and then allowing the resulting layer, typically a film, to slowly cool to room temperature.

The step of annealing can be carried out by heating the substrate coated with the ink composition using any method known to those of ordinary skill in the art, for example, by heating in an oven or on a hot plate. Annealing can be carried out under an inert environment, for example, nitrogen atmosphere or noble gas atmosphere, such as, for example, argon gas. Annealing may be carried out in air atmosphere.

In an embodiment, the annealing temperature is from about 25 °C to about 350 °C, typically from about 150 °C to about 325 °C, more typically from about 200 °C to about 300 °C, still more typically from about 230 °C to about 300 °C.

The annealing time is the time for which the annealing temperature is maintained. The annealing time is from about 3 to about 40 minutes, typically from about 15 to about 30 minutes.

In an embodiment, the annealing temperature is from about 25 °C to about 350 °C, typically from about 150 °C to about 325 °C, more typically from about 200 °C to about 300 °C, still more typically from about 250 °C to about 300 °C, and the annealing time is from about 3 to about 40 minutes, typically for about 15 to about 30 minutes.

The present invention relates to the hole-carrying film formed by the process described herein.

Transmission of visible light is important, and good transmission (low absorption) at higher film thicknesses is particularly important. For example, the film made according to the process of the present invention can exhibit a transmittance (typically, with a substrate) of at least about 85%, typically at least about 90%, of light having a wavelength of about 380-800 nm. In an embodiment, the transmittance is at least about 90%.

In one embodiment, the film made according to the process of the present invention has a thickness of from about 5 nm to about 500 nm, typically from about 5 nm to about 150 nm, more typically from about 50 nm to 120 nm.

In an embodiment, the film made according to the process of the present invention exhibits a transmittance of at least about 90% and has a thickness of from about 5 nm to about 500 nm, typically from about 5 nm to about 150 nm, more typically from about 50 nm to 120 nm. In an embodiment, the film made according to the process of the present invention exhibits a transmittance (%T) of at least about 90% and has a thickness of from about 50 nm to 120 nm.

The films made according to the processes of the present invention may be made on a substrate optionally containing an electrode or additional layers used to improve electronic properties of a final device. The resulting films may be intractable to one or more organic solvents, which can be the solvent or solvents used as the liquid carrier in the ink for subsequently coated or deposited layers during fabrication of a device. The films may be intractable to, for example, toluene, which can be the solvent in the ink for subsequently coated or deposited layers during fabrication of a device.

The present invention also relates to a device comprising a film prepared according to the processes described herein. The devices described herein can be made by methods known in the art including, for example, solution processing. Inks can be applied and solvents removed by standard methods. The film prepared according to the processes described herein may be an HIL and/or HTL layer in the device.

Methods are known in the art and can be used to fabricate organic electronic devices including, for example, OLED and OPV devices. Methods known in the art can be used to measure brightness, efficiency, and lifetimes. Organic light emitting diodes (OLED) are described, for example, in U.S. Patents 4,356,429 and 4,539,507 (Kodak). Conducting polymers which emit light are described, for example, in U.S. Patents 5,247,190 and 5,401,827 (Cambridge Display Technologies). Device architecture, physical principles, solution processing, multilayering, blends, and compounds synthesis and formulation are described in Kraft et al., "Electroluminescent Conjugated Polymers-Seeing Polymers in a New Light," Angew. Chem. Int. Ed., 1998, 37, 402-428, which is hereby incorporated by reference in its entirety.

Light emitters known in the art and commercially available can be used including various conducting polymers as well as organic molecules, such as compounds available from Sumation, Merck Yellow, Merck Blue, American Dye Sources (ADS), Kodak (e.g., A1Q3 and the like), and even Aldrich, such as BEHP-PPV. Examples of such organic electroluminescent compounds include:
(i) poly(p-phenylene vinylene) and its derivatives substituted at various positions on the phenylene moiety;
(ii) poly(p-phenylene vinylene) and its derivatives substituted at various positions on the vinylene moiety;
(iii) poly(p-phenylene vinylene) and its derivatives substituted at various positions on the phenylene moiety and also substituted at various positions on the vinylene moiety;
(iv) poly(arylene vinylene), where the arylene may be such moieties as naphthalene, anthracene, furylene, thienylene, oxadiazole, and the like;
(v) derivatives of poly(arylene vinylene), where the arylene may be as in (iv) above, and additionally have substituents at various positions on the arylene;
(vi) derivatives of poly(arylene vinylene), where the arylene may be as in (iv) above, and additionally have substituents at various positions on the vinylene;
(vii) derivatives of poly(arylene vinylene), where the arylene may be as in (iv) above, and additionally have substituents at various positions on the arylene and substituents at various positions on the vinylene;
(viii) co-polymers of arylene vinylene oligomers, such as those in (iv), (v), (vi), and (vii) with non-conjugated oligomers; and
(ix) poly(p-phenylene) and its derivatives substituted at various positions on the phenylene moiety, including ladder polymer derivatives such as poly(9,9-dialkyl fluorene) and the like;
(x) poly(arylenes) where the arylene may be such moieties as naphthalene, anthracene, furylene, thienylene, oxadiazole, and the like; and their derivatives substituted at various positions on the arylene moiety;
(xi) co-polymers of oligoarylenes, such as those in (x) with non-conjugated oligomers;
(xii) polyquinoline and its derivatives;
(xiii) co-polymers of polyquinoline with p-phenylene substituted on the phenylene with, for example, alkyl or alkoxy groups to provide solubility; and
(xiv) rigid rod polymers, such as poly(p-phenylene-2,6-benzobisthiazole), poly(p-phenylene-2,6-benzobisoxazole), poly(p-phenylene-2,6-benzimidazole), and their derivatives;
(xv) polyfluorene polymers and co-polymers with polyfluorene units.

Preferred organic emissive polymers include SUMATION Light Emitting Polymers ("LEPs") that emit green, red, blue, or white light or their families, copolymers, derivatives, or mixtures thereof; the SUMATION LEPs are available from Sumation KK. Other polymers include polyspirofluorene-like polymers available from Covion Organic Semiconductors GmbH, Frankfurt, Germany (now owned by Merck®).

Alternatively, rather than polymers, small organic molecules that emit by fluorescence or by phosphorescence can serve as the organic electroluminescent layer. Examples of small-molecule organic electroluminescent compounds include: (i) tris(8-hydroxyquinolinato) aluminum (Alq); (ii) 1,3-bis(*N,N*-dimethylaminophenyl)-1,3,4-oxidazole (OXD-8); (iii) -oxo-bis(2-methyl-8-quinolinato)aluminum; (iv) bis(2-methyl-8-hydroxyquinolinato) aluminum; (v) bis(hydroxybenzoquinolinato) beryllium (BeQ₂); (vi) bis(diphenylvinyl)biphenylene (DPVBI); and (vii) arylamine-substituted distyrylarylene (DSA amine).

Such polymer and small-molecule compounds are well known in the art and are described in, for example, U.S. Patent 5,047,687.

The devices can be fabricated in many cases using multilayered structures which can be prepared by, for example, solution or vacuum processing, as well as printing and patterning processes. In particular, use of the embodiments described herein for hole injection layers (HILs), wherein the composition is formulated for use as a hole injection layer, can be carried out effectively.

### Examples of HIL in devices include:

1) Hole injection in OLEDs including PLEDs and SMOLEDs; for example, for HIL in PLED, all classes of conjugated polymeric emitters where the conjugation involves carbon or silicon atoms can be used. For HIL in SMOLED, the following are examples: SMOLED containing fluorescent emitters; SMOLED containing phosphorescent emitters; SMOLEDs comprising one or more organic layers in addition to the HIL layer; and SMOLEDs where the small molecule layer is processed from solution or aerosol spray or any other processing methodology. In addition, other examples include HIL in dendrimer or oligomeric organic semiconductor based OLEDs; HIL in ambipolar light emitting FET's where the HIL is used to modify charge injection or as an electrode;
2) Hole extraction layer in OPV;
3) Channel material in transistors;
4) Channel material in circuits comprising a combination of transistors, such as logic gates;
5) Electrode material in transistors;
6) Gate layer in a capacitor;
7) Chemical sensor where modification of doping level is achieved due to association of the species to be sensed with the conductive polymer;
8) Electrode or electrolyte material in batteries.

A variety of photoactive layers can be used in OPV devices. Photovoltaic devices can be prepared with photoactive layers comprising fullerene derivatives mixed with, for example, conducting polymers as described in, for example, U.S. Patents 5,454,880; 6,812,399; and 6,933,436. Photoactive layers may comprise blends of conducting polymers, blends of conducting polymers and semiconducting nanoparticles, and bilayers of small molecules such as phthalocyanines, fullerenes, and porphyrins.

Common electrode compounds and substrates, as well as encapsulating compounds can be used.

In one embodiment, the cathode comprises Au, Ca, Al, Ag, or combinations thereof. In one embodiment, the anode comprises indium tin oxide. In one embodiment, the light emission layer comprises at least one organic compound.

Interfacial modification layers, such as, for example, interlayers, and optical spacer layers may be used.

Electron transport layers can be used.

The present invention also relates to a method of making a device described herein.

In an embodiment, the method of making a device comprises: providing a substrate; layering a transparent conductor, such as, for example, indium tin oxide, on the substrate; providing the ink composition described herein; layering the ink composition on the transparent conductor to form a hole injection layer or hole transport layer; layering an active layer on the hole injection layer or hole transport layer (HTL); and layering a cathode on the active layer.

As described herein, the substrate can be flexible or rigid, organic or inorganic. Suitable substrate compounds include, for example, glass, ceramic, metal, and plastic films.

In another embodiment, a method of making a device comprises applying the ink composition as described herein as part of an HIL or HTL layer in an OLED, a photovoltaic device, an ESD, a SMOLED, a PLED, a sensor, a supercapacitor, a cation transducer, a drug release device, an electrochromic device, a transistor, a field effect transistor, an electrode modifier, an electrode modifier for an organic field transistor, an actuator, or a transparent electrode.

The layering of the ink composition to form the HIL or HTL layer can be carried out by methods known in the art including, for example, spin casting, spin coating, dip casting, dip coating, slot-dye coating, inkjet printing, gravure coating, doctor blading, and any other methods known in the art for fabrication of, for example, organic electronic devices. The layering of the ink composition is preferably carried out by inkjet printing.

In one embodiment, the HIL layer is thermally annealed. In one embodiment, the HIL layer is thermally annealed at temperature of about 25 °C to about 350 °C, typically 150 °C to about 325 °C. In one embodiment, the HIL layer is thermally annealed at temperature of about 25 °C to about 350 °C, typically 150 °C to about 325 °C, for about 3 to about 40 minutes, typically for about 15 to about 30 minutes.

In one embodiment, the HIL layer has a thickness of from about 5 nm to about 500 nm, typically from about 5 nm to about 150 nm, more typically from about 50 nm to 120 nm.

In an embodiment, the HIL layer exhibits a transmittance of at least about 90% and has a thickness of from about 5 nm to about 500 nm, typically from about 5 nm to about 150 nm, more typically from about 50 nm to 120 nm. In an embodiment, the HIL layer exhibits a transmittance (%T) of at least about 90% and has a thickness of from about 50 nm to 120 nm.

The ink composition and the organic EL device according to the present invention are further illustrated by the following non-limiting examples.

### Examples

The meanings of abbreviations used in the following examples are as follows.
MMA: Methyl methacrylate
HEMA: 2-Hydroxyethyl methacrylate
HPMA: 4-Hydroxyphenyl methacrylate
HPMA-QD: Compound synthesized by condensation reaction of 1 mol of 4-hydroxyphenyl methacrylate and 1.1 mol of 1,2-naphthoquinone-2-diazide-5-sulfonyl chloride
CHMI: *N*-cyclohexylmaleimide
PFHMA: 2-(Perfluorohexyl)ethyl methacrylate
MAA: Methacrylic acid
AIBN: α, α'-Azobisisobutyronitrile
QD1: Compound synthesized by condensation reaction of 1 mol of α, α, α'-tris(4-hydroxyphenyl)-1-ethyl-4-isopropylbenzene and 1.5 mol of 1,2-naphthoquinone-2-diazide-5-sulfonyl chloride
GT-401: Butanetetracarboxylic acid tetra(3,4-epoxycyclohexylmethyl) modified ε-caprolactone (trade name: Epolide GT-401 (manufactured by Daicel Corporation))
PGME: Propylene glycol monomethyl ether
PGMEA: Propylene glycol monomethyl ether acetate
CHN: cyclohexanone

The components used in the following examples are summarized in Tables 1 and 2 below.

**Table 1.**

| S-poly(3-MEET) | Sulfonated poly(3-MEET) |
|---|---|
| TFE-VEFS 1 | TFE/perfluoro-2-(vinyloxy)ethane-1-sulfonic acid copolymer having equivalent weight of 676 g polymer/mol acid (available from Solvay as AQUIVION® D66-20BS); n:m = 8:2 |
| EG-ST | 20-21 wt. % silica dispersion in ethylene glycol (EG-ST, available from Nissan Chemical Industries); average particle diameter: 12 nm; particle diameter measured by BET method |
| EG silica sol (1) | 20.5 wt. % silica dispersion in ethylene glycol (a dispersion prepared by replacing the solvent in ST-O-40, available from Nissan Chemical Industries, which is a water-dispersed sol of silica having an average primary particle diameter of 21 nm, with ethylene glycol); particle diameter measured by BET method |
| EG silica sol (2) | 10.5 wt. % silica dispersion in ethylene glycol (a dispersion prepared by replacing the solvent in ST-OXS, available from Nissan Chemical Industries, which is a water-dispersed sol of silica having an average primary particle diameter of 5 nm, with ethylene glycol); particle diameter measured by sodium hydroxide titration in accordance with the following reference: |
| | George W. Sears Jr., Anal. Chem. 28 (12), pp. 1981-1983 (1956) |
| Ammonia water | 28% Aqueous ammonia solution |
| 2-EHA | 2-Ethylhexylamine |
| EG | Ethylene glycol |
| DEG | Diethylene glycol |
| TEG | Triethylene glycol |
| DEGnBE | Diethylene glycol monobutyl ether |
| DEGiBE | Diethylene glycol monoisobutyl ether |
| DEGDBE | Diethylene glycol dibutyl ether |
| TEGBME | Triethylene glycol butyl methyl ether |

**Table 2.**

| Methanol silica sol | 32-33 wt. % silica dispersion in methanol (MT-ST, available from Nissan Chemical Corporation); average particle diameter: 12 nm; particle diameter measured by BET method |
|---|---|
| PG | Propylene glycol |
| DPG | Dipropylene glycol |
| TPG | Tripropylene glycol |
| PC | Propylene carbonate |
| DiPM | Diisopropyl malonate |
| TEGBE | Triethylene glycol monobutyl ether |
| DPGBE | Dipropylene glycol monobutyl ether |

In the following examples, the arylsulfonic acids represented by the following formulas may be used.

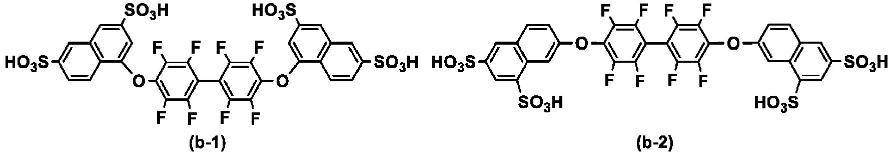

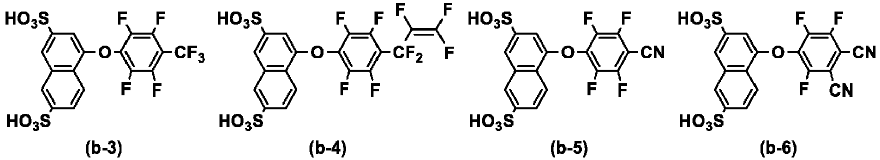

.

### (1) Preparation of charge transporting materials

### Production Example 1

### Preparation of amine adduct of S-poly(3-MEET)

500 g of an aqueous dispersion of S-poly(3-MEET) (0.598% solids in water) was mixed with 0.858 g of triethylamine, and the resulting mixture was evaporated to dryness by rotary evaporation. The resulting residue was then further dried using a vacuum oven at 50 °C overnight to give an amine adduct of S-poly(3-MEET) as 3.8 g of a black powder product.

### Production Example 2

2.00 g of the amine adduct of S-poly(3-MEET) obtained in Production Example 1 was dissolved in 100 ml of 28% ammonia water (manufactured by Junsei Chemical Co., Ltd.) and the resulting solution was stirred at room temperature overnight. The resulting reaction mixture was subjected to reprecipitation with 1,500 mL of acetone, and the precipitate was collected by filtration. The obtained precipitate was dissolved again in 20 mL of water and 7.59 g of triethylamine (manufactured by Tokyo Chemical Industries Co., Ltd.) and stirred at 60 °C for 1 hour. After the resulting reaction mixture was cooled, it was subjected to reprecipitation with a mixed solvent of 1,000 mL of isopropyl alcohol and 500 mL of acetone, and the precipitate was collected by filtration. The obtained precipitate was dried in vacuo (0 mmHg) at 50 °C for 1 hour to obtain 1.30 g of S-poly(3-MEET)-A, which is a charge transporting material treated with ammonia water.

### (2) Preparation of charge transporting varnishes

### Example 1

First, the solvent in an aqueous solution D66-20BS was evaporated using an evaporator, and the resultant residue was dried at 80 °C for 1 hour under reduced pressure using a vacuum drier, to obtain a powder of D66-20BS. The obtained powder was used to prepare a 5 wt. % solution of D66-20BS in ethylene glycol. This solution was prepared by stirring at 400 rpm at 80 °C for 1 hour using a hot stirrer.

Next, another vessel was provided, and 0.020 g of S-poly(3-MEET)-A, obtained in Production Example 2, was dissolved in 1.59 g of ethylene glycol (manufactured by Kanto Chemical Co., Inc.), 0.49 g of triethylene glycol (manufactured by Kanto Chemical Co., Inc.), 1.95 g of triethylene glycol butyl methyl ether (manufactured by Tokyo Chemical Industry Co., Ltd.), 4.88 g of diethylene glycol monobutyl ether (manufactured by Kanto Chemical Co., Inc.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.20 g of the 5 wt. % ethylene glycol solution of D66-20BS, and the resultant mixture was stirred for 10 minutes at 400 rpm at room temperature using a stirrer. Finally, 0.83 g of EG-ST was added, the resultant mixture was stirred using a stirrer at 400 rpm at room temperature for 10 minutes, and the resulting dispersion was filtered through a PP syringe filter (pore size: 0.2 µm) to yield a 2 wt. % charge transporting varnish.

### Example 2

Charge transporting varnish B was obtained in the same manner as in Example 1, except that the solvent was changed to 1.59 g of ethylene glycol (manufactured by Kanto Chemical Co., Inc.), 0.49 g of triethylene glycol (manufactured by Kanto Chemical Co., Inc.), 2.93 g of triethylene glycol butyl methyl ether (manufactured by Tokyo Chemical Industry Co., Ltd.), and 3.91 g of diethylene glycol monoisobutyl ether (manufactured by Kanto Chemical Co., Inc.).

### Example 3

Charge transporting varnish C was obtained in the same manner as in Example 1, except that the solvent was changed to 1.33 g of ethylene glycol (manufactured by Kanto Chemical Co., Inc.), 0.68 g of triethylene glycol (manufactured by Kanto Chemical Co., Inc.), 2.93 g of triethylene glycol butyl methyl ether (manufactured by Tokyo Chemical Industry Co., Ltd.), and 3.91 g of diethylene glycol monobutyl ether (manufactured by Kanto Chemical Co., Inc.) and the 0.83 g of EG-ST was replaced with 0.75 g of EG-ST and 0.15 g of EG silica sol (2).

### Example 4

Charge transporting varnish D was obtained in the same manner as in Example 1, except that the solvent was changed to 1.52 g of ethylene glycol (manufactured by Kanto Chemical Co., Inc.), 0.49 g of triethylene glycol (manufactured by Kanto Chemical Co., Inc.), 2.93 g of triethylene glycol butyl methyl ether (manufactured by Tokyo Chemical Industry Co., Ltd.), and 3.91 g of diethylene glycol monobutyl ether (manufactured by Kanto Chemical Co., Inc.) and the 0.83 g of EG-ST was replaced with 0.75 g of EG-ST and 0.15 g of EG silica sol (2).

### Example 5

Charge transporting varnish G was obtained in the same manner as in Example 1, except that the solvent was changed to 1.03 g of ethylene glycol (manufactured by Kanto Chemical Co., Inc.), 0.98 g of triethylene glycol (manufactured by Kanto Chemical Co., Inc.), 2.93 g of triethylene glycol butyl methyl ether (manufactured by Tokyo Chemical Industry Co., Ltd.), and 3.91 g of diethylene glycol monobutyl ether (manufactured by Kanto Chemical Co., Inc.) and the 0.83 g of EG-ST was replaced with 0.75 g of EG-ST and 0.15 g of EG silica sol (2).

### Comparable Example 1

Charge transporting varnish F was obtained in the same manner as in Example 1, except that the solvent was changed to 0.62 g of ethylene glycol (manufactured by Kanto Chemical Co., Inc.), 1.47 g of diethylene glycol (manufactured by Kanto Chemical Co., Inc.), 1.95 g of diethylene glycol dibutyl ether (manufactured by Tokyo Chemical Industry Co., Ltd.), and 4.88 g of diethylene glycol monobutyl ether (manufactured by Kanto Chemical Co., Inc.).

The compositions of the solvents used in Examples 1-5 and Comparative Example 1 are shown in Table 3 below.

**Table 3.**

| | Example 1 | Example 2 | Example 3 | Example 4 | Example 5 | Comparative Example 1 |
|---|---|---|---|---|---|---|
| EG (g) | 2.44 | 2.44 | 2.26 | 2.45 | 1.95 | 1.47 |
| DEG (g) | | | | | | 1.47 |
| TEG (g) | 0.49 | 0.49 | 0.68 | 0.49 | 0.98 | |
| TEGBME (g) | 1.95 | 2.93 | 2.93 | 2.93 | 2.93 | |
| DEGnBE (g) | 4.88 | | 3.91 | 3.91 | 3.91 | 4.88 |
| DEGDBE (g) | | | | | | 1.95 |
| DEGiBE(g) | | 3.91 | | | | |
| Proportion of EG (%) | 25 | 25 | 23 | 25 | 20 | 15 |
| Proportion of TEG or DEG (%) | 5 | 5 | 7 | 5 | 10 | 15 |
| Total amount of solvents | 9.76 | 9.77 | 9.78 | 9.78 | 9.77 | 9.77 |

### Example 6

First, the solvent of methanol contained in MT-ST was replaced with TPG using an evaporator to obtain TPG-ST, a 20.6 wt% silica dispersion.

A propylene glycol solution containing the arylsulfonic acid represented by formula (b-1) above (arylsulfonic acid B) at a concentration of 10 mass% was prepared. The solution was prepared by stirring for 1 hour at 400 rpm and 50°C using a hot stirrer.

Next, another vessel was provided, and 0.020 g of S-poly(3-MEET)-A, obtained in Production Example 2, was dissolved in 0.71 g of propylene glycol (manufactured by Junsei Chemical Co., Ltd.), 2.391 g of tripropylene glycol (manufactured by Kanto Chemical Co., Inc.), 2.930 g of propylene carbonate (manufactured by Tokyo Chemical Industry Co., Ltd.), 0.977 g of dipropylene glycol monobutyl ether (manufactured by FUJIFILM Wako Pure Chemical Corporation), 1.954 g of diisopropyl malonate (manufactured by Tokyo Chemical Industry Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.30 g of the 10 wt% solution of formula (b-1) above in propylene glycol, and the resultant mixture was stirred for 10 minutes at 400 rpm at room temperature using a stirrer. Subsequently, 0.68 g of TPG-ST was added, and the resultant mixture was stirred using a stirrer at 400 rpm at room temperature for 10 minutes. Finally, 0.01 g of KBM-7103 (manufactured by Shin-Etsu Chemical Co., Ltd.) was added, the resultant mixture was stirred using a stirrer at 400 rpm at room temperature for 10 minutes, and the resulting dispersion was filtered through a PP syringe filter (pore size: 0.2 µm) to yield a 2 wt. % charge transporting varnish H.

### Example 7

A dipropylene glycol solution containing the arylsulfonic acid represented by formula (b-1) above (arylsulfonic acid B) at a concentration of 10 mass% was prepared. The solution was prepared by stirring for 1 hour at 400 rpm and 50°C using a hot stirrer.

Next, another vessel was provided, and 0.020 g of S-poly(3-MEET)-A, obtained in Production Example 2, was dissolved in 0.71 g of dipropylene glycol (manufactured by Junsei Chemical Co., Ltd.), 1.414 g of tripropylene glycol (manufactured by Kanto Chemical Co., Inc.), 1.945 g of propylene carbonate (manufactured by Tokyo Chemical Industry Co., Ltd.), 1.954 g of triethylene glycol monobutyl ether (1.954 g Tokyo Chemical Industry Co., Ltd.), 2.930 g of diisopropyl malonate (manufactured by Tokyo Chemical Industry Co., Ltd.), and 0.032 g of 2-ethylhexylamine (manufactured by Tokyo Chemical Industry Co., Ltd.). The solution was prepared by stirring at 80 °C for 1 hour using a hot stirrer. Then, to the resultant solution was added 0.30 g of the 10 wt% solution of formula (b-1) above in propylene glycol, and the resultant mixture was stirred for 10 minutes at 400 rpm at room temperature using a stirrer. Subsequently, 0.68 g of TPG-ST, produced in Example 6, was added, and the resultant mixture was stirred using a stirrer at 400 rpm at room temperature for 10 minutes. Finally, 0.01 g of KBM-7103 (manufactured by Shin-Etsu Chemical Co., Ltd.) was added, the resultant mixture was stirred using a stirrer at 400 rpm at room temperature for 10 minutes, and the resulting dispersion was filtered through a PP syringe filter (pore size: 0.2 µm) to yield a 2 wt. % charge transporting varnish I.

The compositions (wt %) of the solvents in Examples 6-7 are shown in Table 4 below.

**Table 4.**

| Example 6 | | Example 7 | |
|---|---|---|---|
| PG | 10 | DPG | 10 |
| TPG | 30 | TPG | 20 |
| PC | 30 | PC | 20 |
| DPGBE | 10 | TEGBE | 20 |
| DiPM | 20 | DiPM | 30 |

### (3) Preparation of positive photosensitive resin compositions

### [Measurement of Number Average Molecular Weight and Weight Average Molecular Weight]

The number average molecular weights and weight average molecular weights of the copolymers obtained in accordance with the following synthesis examples were measured by gel permeation chromatography under the following conditions.
- Chromatograph: GPC system manufactured by Shimadzu Corporation
   Detector (RID10A)
   Solvent delivery unit (LC-20AD)
   Column oven (CTO20A)
- Column: Shodex KF-804L and 803L (manufactured by Showa Denko Co., Ltd.) connected in series
- Eluent: Tetrahydrofuran
- Flow rate: 1 ml/min
- Column temperature: 40 °C

The number average molecular weights (hereinafter referred to as Mn) and weight average molecular weights (hereinafter referred to as Mw) below are expressed in polystyrene equivalents.

### <Synthesis Example 1>

10.0 g of MMA, 12.5 g of HEMA, 20.0 g of CHMI, 2.50 g of HPMA, 5.00 g of MAA, 3.20 g of AIBN were dissolved in 79.8 g of PGME and allowed to react at 60 °C to 100 °C for 20 hours to obtain an acrylic polymer solution (solids concentration: 40% by weight) (P1). The Mn and Mw of the obtained acrylic polymer P1 were 3,700 and 6,100, respectively.

### <Synthesis Example 2>

2.50 g of HPMA-QD, 7.84 g of PFHMA, 0.70 g of MAA, 1.46 g of CHMI, 0.33 g of AIBN were dissolved in 51.3 g of CHN and allowed to react at 110 °C for 20 hours while stirring to obtain an acrylic polymer solution (solids concentration: 20% by weight) (P2). The Mn and Mw of the obtained acrylic polymer P2 were 4,300 and 6,300, respectively.

A positive photosensitive resin composition was prepared by mixing 5. 04 g of P1, obtained in Synthesis Example 1, 0.05 g of P2, obtained in Synthesis Example 2, 0. 40 g of QD1, 0.09 g of GT-401, and 6.42 g of PGMEA, and stirring the mixture at room temperature for 3 hours to obtain a uniform solution.

### (4) Fabrication of a banked substrate

After the positive photosensitive resin composition obtained in step (3) above was applied using a spin coater onto a ITO-glass substrate that had been ozone-cleaned for 10 minutes using a UV-312, manufactured by Technovision Inc., the substrate was subjected to pre-baking (heated at 100 °C for 120 seconds) on a hot plate to form a film having a thickness of 1.2 µm. This film was irradiated with ultraviolet light (light intensity at 365 nm: 5.5 mW/cm²) for a certain period by an ultraviolet irradiator PLA-600FA, manufactured by Canon Inc., through a patterned mask having a large number of rectangular windows with a long side of 200 µm and a short side of 100 µm. Thereafter, the film was immersed in a 1.0% aqueous solution of TMAH for 120 seconds for development, and then the film was washed in flowing ultrapure water for 20 seconds. Next, the film on which rectangular patterns were formed was subjected to post-baking (heating at a temperature of 230 °C for 30 minutes) for curing, thereby obtaining a banked substrate.

### (5) Evaluation of film formability

The charge transporting varnishes obtained in Examples 1 to 7 and Comparative Example 1 were discharged into rectangular openings (film formation regions) on the banked substrate obtained in step (4) above using a Inkjet Designer, manufactured by Cluster Technology Co., Ltd., and the obtained coating films were dried under reduced pressure for 15 minutes at a reduced pressure (degree of vacuum) of 10 Pa or less, and then dried at 230 °C for 30 minutes on a hot plate to form a charge transporting film.

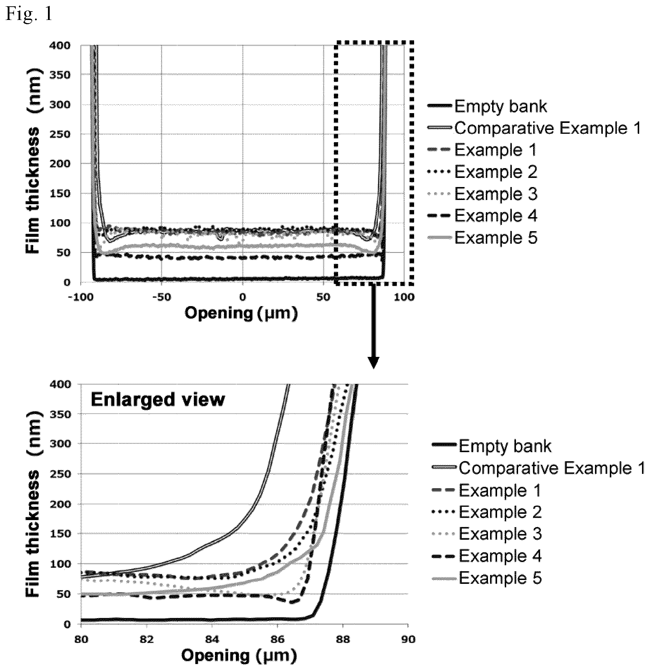

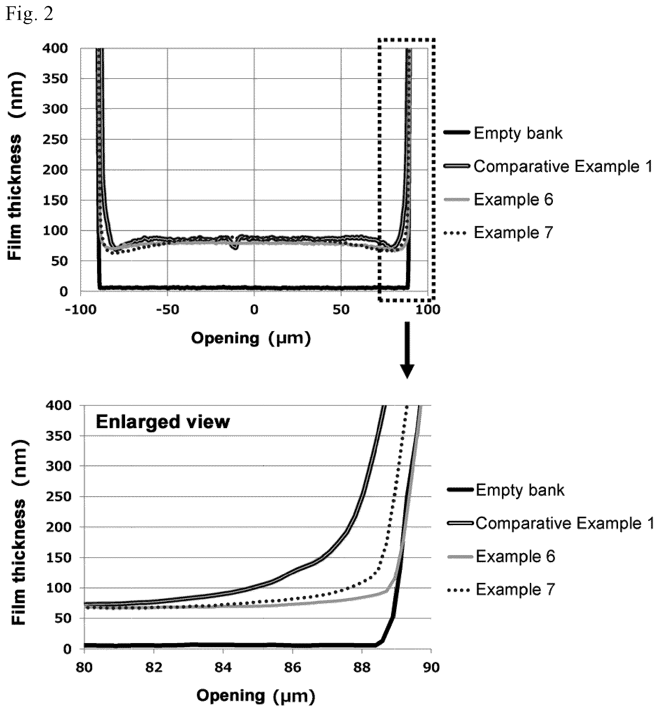

The cross-sectional shapes of the charge transporting films obtained for Examples 1 to 7 and Comparative Example 1 were measured using a fine shape measuring instrument ET4000A (manufactured by Kosaka Laboratory Ltd.). The results obtained for the respective openings are shown in FIG. 1 (Examples 1 to 5 and Comparative Example 1) and FIG. 2 (Examples 6 to 7 and Comparative Example 1).

Comparison of Examples 1 to 5 with Comparative Example 1 (FIG. 1) shows that the cross-sectional shapes of the charge transporting films obtained in the Examples exhibit clearly less climbing (increase in film thickness) in the vicinity of the banks than the cross section of the film obtained in the Comparative Example. That is, in the Examples, pile-up is suppressed as compared with the Comparative Example. The results above have confirmed that using non-aqueous ink compositions of the present invention allow the suppression of the pile-up at the time of forming the charge transporting film. Thus, it is expected that, in the organic EL device obtained by using the non-aqueous ink compositions of the present invention, the shortening of lifetime due to electrical defects and the uneven emission of light due to the uneven thickness of the light emitting layer are greatly ameliorated without excessively deteriorating other characteristics.

Comparison of Examples 6 to 7 with Comparative Example 1 (FIG. 2) shows that the cross-sectional shapes of the charge transporting films obtained in the Examples exhibit clearly less climbing (increase in film thickness) in the vicinity of the banks than the cross section of the film obtained in the Comparative Example. That is, in the Examples, pile-up is suppressed as compared with the Comparative Example.

### (6) Fabrication and characterization of organic EL devices

The varnishes obtained in Examples 1 and 6 to 7 and Comparative Example 1 were each applied to a banked ITO substrate using a spin coater, and were then dried under a reduced pressure (degree of vacuum) of 10 Pa or lower in air for 15 minutes. Subsequently, the dried substrate was placed into a glove box and baked at 230 °C for 30 minutes to form a film, 50 nm thick, on the substrate. For the banked ITO substrate, a banked ITO substrate was used that was prepared by forming a film of a polyimide resin having a thickness of 1.1 µm on the electrodes on a glass substrate (25 mm × 25 mm × 0.7 t) on the surface of which patterned thin film electrodes of indium tin oxide (ITO) having a thickness of 150 nm were formed and patterning the film (with many 2 mm × 2 mm squares) to form banks; the impurities on the surface of the glass substrate were removed by an O₂ plasma cleaning device (150 W, 30 seconds) prior to use.

Next, α-NPD (*N,N*-di(1-naphthyl)-*N,N*-diphenylbenzidine) was deposited using an vacuum evaporator (degree of vacuum: 1.0 × 10⁻⁵ Pa) to a thickness of 30 nm at a rate of 0.2 nm/s on the banked ITO substrate on which the film was formed. Then, a 10 nm layer of HTEB-01, an electron blocking material manufactured by Kanto Chemical Co., Inc., was formed. Subsequently, NS60, a light-emitting layer host material manufactured by Nippon Steel & Sumikin Chemical Co., Inc., and Ir(PPy)₃, a light-emitting layer dopant material, were co-deposited. For the codeposition, the deposition rate was controlled so that the concentration of Ir(PPy)₃ was 6%, and the layer was deposited to 40 nm. Next, films of Alq₃, lithium fluoride and aluminum were successively layered to obtain an organic electroluminescent device. In these steps, the deposition rates were set to 0.2 nm/s for Alq₃, 0.2 nm/s for aluminum, and 0.02 nm/s for lithium fluoride and the film thicknesses were set to 20 nm, 0.5 nm, and 80 nm, respectively.

In order to prevent deterioration in characteristics under the influence of, among others, oxygen and water in the air, the organic EL device was sealed using sealing substrates before the characteristics thereof were evaluated. Sealing was performed by the following procedure. The organic EL device was placed between sealing substrates in a nitrogen atmosphere having an oxygen concentration of 2 ppm or lower and a dew point of -76 °C or lower, and the sealing substrates were bonded to each other using an adhesive (Moresco Moisture Cut WB90US (P), manufactured by MORESCO Corporation). In this step, a water-trapping agent (HD-071010W-40, manufactured by Dynic Corporation) was placed between the sealing substrates together with the organic EL device, and the sealing substrates stuck together were irradiated with UV light (wavelength: 365 nm, irradiation level: 6,000 mJ/cm²), and then annealed at 80 °C for 1 hour to cure the adhesive.

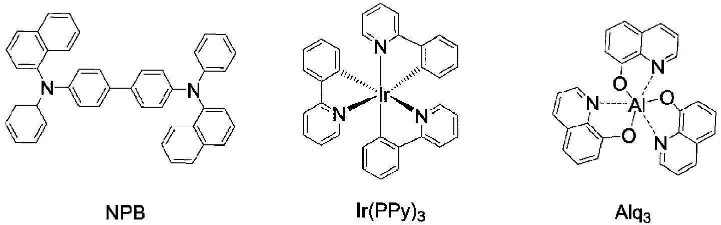

For the organic EL devices fabricated using the varnishes obtained in Example 1 and Comparative Example 1, among those obtained above, the drive voltage, current density and luminous efficiency as well as the luminance lifetime LT70 (time elapsed before luminance, from an initial value of 10,000 cd/m², decreases by 30%) were measured for when they were driven at a luminance of 10,000 cd/m². The results are shown in Table 5.

**Table 5.**

| | Drive voltage (V) | Current density (mA/cm²) | Current efficiency (cd/A) | External quantum efficiency (%) | Luminance lifetime LT70 (h) |
|---|---|---|---|---|---|
| Example 1 | 5.2 | 22.3 | 45.0 | 12.9 | 165.0 |
| Comparative Example 1 | 5.1 | 23.0 | 26.8 | 12.5 | 75.0 |

For the organic EL devices fabricated using the varnishes obtained in Examples 6 to 7 and Comparative Example 1, among those obtained above, the drive voltage, current density and luminous efficiency as well as the luminance lifetime LT70 (time elapsed before luminance, from an initial value of 10,000 cd/m², decreases by 30%) were measured for when they were driven at a luminance of 10,000 cd/m². The results are shown in Table 6.

**Table 6.**

| | Drive voltage (V) | Current density (mA/cm²) | Current efficiency (cd/A) | External quantum efficiency (%) | Luminance lifetime LT70 (h) |
|---|---|---|---|---|---|
| Example 6 | 5.4 | 19.6 | 51.0 | 14.6 | 150.0 |
| Example 7 | 6.0 | 19.8 | 50.6 | 14.5 | 90.0 |
| Comparative Example 1 | 5.4 | 25.3 | 39.7 | 11.4 | 75.0 |

As is shown in Tables 5 and 6, the organic EL devices fabricated using the non-aqueous ink compositions of the present invention exhibited an improved current efficiency and an extended luminance lifetime, which is a reflection of the suppression of pile-up.

## Claims

1. An ink composition comprising:
(a) a charge transporting material;
(b) one or more metal oxide nanoparticles; and
(c) a liquid carrier comprising:
(c-1) a first hydrophilic glycol-based solvent having a boiling point of bp¹ (°C),
(c-2) a second hydrophilic glycol-based solvent having a boiling point of bp² (°C), and
(c-3) an organic solvent having a boiling point of bp³ (°C),
wherein bp¹ < bp³ < bp².

2. The ink composition according to claim 1, wherein the solvent (c-3) is a hydrophobic glycol-based solvent, a nitrile, an alcohol, an aromatic ether, an aromatic ester, or an aromatic hydrocarbon.

3. The ink composition according to claim 1 or 2, wherein the solvent (c-3) is a hydrophobic glycol-based solvent.

4. The ink composition of any one of claims 1 to 3, wherein the solvents (c-1) and (c-2) are both glycol solvents and the solvent (c-3) is a glycol diether solvent.

5. The ink composition of any one of claims 1 to 4, wherein bp¹ is 180°C or higher, bp² is 270°C or higher, and bp³ is 200°C or higher and lower than 270°C.

6. The ink composition of claim 1, wherein the solvent (c-3) is a mixture of two or more organic solvents, comprising one or more glycol diether solvents.

7. The ink composition of any one of claims 1 to 6, wherein the solvent (c-1) is ethylene glycol and the solvent (c-2) is triethylene glycol.

8. The ink composition of any one of claims 1 to 7, wherein the weight ratio ((c-1) : (c-2)) of the solvent (c-1) to the solvent (c-2) is 29:1 to 8:7.

9. The ink composition of any one of claims 1 to 8, wherein the weight of the solvent (c-1) is 16 to 29% of the total weight of the liquid carrier (c), and the weight of the solvent (c-2) is 14 to 1% of the total weight of the liquid carrier (c).

10. The ink composition according to any one of claims 1 to 9, wherein the metal oxide nanoparticles (b) comprise B₂O₃, B₂O, SiO₂, SiO, GeO₂, GeO, As₂O₄, As₂O₃, As₂Os, Sb₂O₃, TeO₂, SnO₂, SnO, or mixtures thereof.

11. The ink composition according to claim 10, wherein the metal oxide nanoparticles (b) comprise SiO₂.

12. The ink composition according to any one of claims 1 to 11, wherein the charge transporting material (a) is a polythiophene.

13. The ink composition according to claim 12, wherein the polythiophene is a polythiophene comprising a repeating unit represented by formula (I) below: 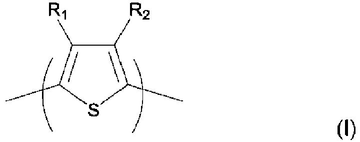 wherein R₁ and R₂ are each, independently, H, alkyl, fluoroalkyl, alkoxy, fluoroalkoxy, aryloxy, -SO₃M, or -O-[Z-O]ₚ-Rₑ; or R₁ and R₂ together form -O-Z-O-;
wherein
M is H, an alkali metal, ammonium, a monoalkylammonium, a dialkylammonium, or a trialkylammonium,
Z is a hydrocarbylene group optionally substituted with a halogen or Y, wherein Y is a straight or branched chain alkyl or alkoxyalkyl group having 1 to 10 carbons, wherein the alkyl or alkoxyalkyl group may be substituted at any position with a sulfonic acid group,
p is an integer equal to or greater than 1, and
Rₑ is H, alkyl, fluoroalkyl, or aryl.

14. The ink composition according to claim 13, wherein R₁ and R₂ are each, independently, H, fluoroalkyl, -SO₃M, -O[C(RₐR_{b})-C(R_{c}R_{d})-O]ₚ-Rₑ, or -OR_{f}; or R₁ and R₂ together form -O-(CH₂)_{q}-O-, wherein (CH₂)_{q} is optionally substituted with Y;
wherein M is H, an alkali metal, ammonium, a monoalkylammonium, a dialkylammonium, or a trialkylammonium, and each occurrence of Rₐ, R_{b}, R_{c}, and R_{d} is each, independently, H, halogen, alkyl, fluoroalkyl, or aryl; Re is H, alkyl, fluoroalkyl, or aryl; p is 1, 2, or 3; and R_{f} is alkyl, fluoroalkyl, or aryl; q is 1, 2, or 3; and Y is a straight or branched chain alkoxyalkyl group having 1 to 10 carbons, wherein the alkoxyalkyl group may be substituted at any position with a sulfonic acid group.

15. The ink composition according to claim 14, wherein R₁ is H and R₂ is other than H.

16. The ink composition according to claim 14, wherein R₁ and R₂ are both other than H.

17. The ink composition according to claim 16, wherein R₁ and R₂ are each, independently, -O[C(RₐR_{b})-C(R_{c}R_{d})-O]ₚ-Rₑ, or -OR_{f}; or R₁ and R₂ together form -O-(CH₂)_{q}-O-.

18. The ink composition according to claim 17, wherein R₁ and R₂ are both - O[C(RₐR_{b})-C(R_{c}R_{d})-O]ₚ-Rₑ.

19. The ink composition according to claim 14, wherein each occurrence of Rₐ, R_{b}, R_{c}, and R_{d} is each, independently, H, (C₁-C₈) alkyl, (C₁-C₈) fluoroalkyl, or phenyl; and Rₑ is (C₁-C₈) alkyl, (C₁-C₈) fluoroalkyl, or phenyl.

20. The ink composition according to any one of claims 12 to 14, wherein the polythiophene comprises a repeating unit selected from the group consisting of 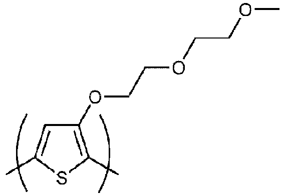 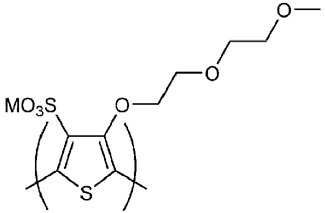 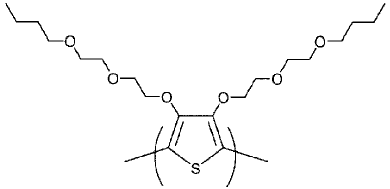 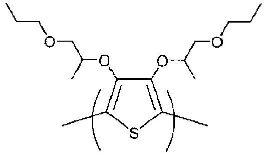 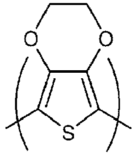 and combinations thereof, wherein M is H, an alkali metal, ammonium, a monoalkylammonium, a dialkylammonium, or a trialkylammonium;

21. The ink composition according to any one of claims 12 to 20, wherein the polythiophene is sulfonated.

22. The ink composition according to any one of claims 12 to 21, wherein the polythiophene is sulfonated poly(3-MEET).

23. The ink composition according to any one of claims 12 to 22, wherein the polythiophene comprises repeating units represented by formula (I) above in an amount of greater than 50% by weight, typically greater than 80% by weight, more typically greater than 90% by weight, even more typically greater than 95% by weight, based on the total weight of the repeating units.

24. The ink composition according to any one of claims 1 to 23, further comprising a synthetic polymer comprising one or more acidic groups.

25. The ink composition according to claim 24, wherein the synthetic polymer is a polymeric acid comprising one or more repeating units comprising at least one alkyl or alkoxy group substituted by at least one fluorine atom and at least one sulfonic acid (-SO₃H) moiety, wherein said alkyl or alkoxy group is optionally interrupted by at least one ether linking (-O-) group.

26. The ink composition according to claim 25, wherein the polymeric acid comprises a repeating unit represented by formula (II) below and a repeating unit represented by formula (III) below: 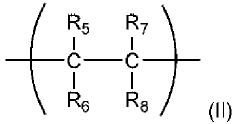 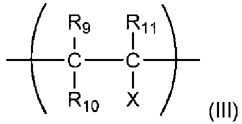 wherein
each occurrence of R₅, R₆, R₇, R₈, R₉, R₁₀, and R₁₁ is, independently, H, halogen, fluoroalkyl, or perfluoroalkyl; and
X is -[OC(RₕRᵢ)-C(RⱼRₖ)]_{q}-O-[CRₗRₘ],-SO₃H,
wherein
each occurrence of Rₕ, Rᵢ, Rⱼ, Rₖ, Rₗ and Rₘ is, independently, H, halogen, fluoroalkyl, or perfluoroalkyl;
q is 0 to 10; and
z is 1 to 5.

27. The ink composition according to claim 24, wherein the synthetic polymer is a polyether sulfone comprising one or more repeating units comprising at least one sulfonic acid (-SO₃H) moiety.

28. The ink composition according to any one of claims 1 to 27, further comprising at least one amine compound.

29. The ink composition according to claim 28, wherein the amine compound comprises a tertiary alkylamine compound and an amine compound other than a tertiary alkylamine compound.

30. The ink composition according to claim 29, wherein the amine compound other than a tertiary alkylamine compound is a primary alkylamine compound.

31. The ink composition according to claim 30, wherein the primary alkylamine compound is at least one selected from the group consisting of ethylamine, n-butylamine, t-butylamine, n-hexylamine, 2-ethylhexylamine, n-decylamine, and ethylenediamine.

32. The ink composition according to claim 30, wherein the primary alkylamine compound is 2-ethylhexylamine or n-butylamine.
